# EUROPÄISCHE PATENTSCHRIFT

(11) **EP 1 820 227 B1**
(45) Veröffentlichungstag und Bekanntmachung des Hinweises auf die Patenterteilung: **07.05.2014**
(21) Anmeldenummer: 05813343.0
(22) Anmeldetag: 06.12.2005
(51) Int. Cl.: H01L 51/00, C07F 15/00, C07F 19/00, C09K 11/06, H01L 51/50

(54) **METALLKOMPLEXE UND DEREN VERWENDUNG ALS DIE EMITTIERENDE KOMPONENTE IN ELEKTRONISCHEN BAUTEILEN, BESONDERS IN ELEKTROLUMINESZENTEN ANZEIGEVORRICHTUNGEN**
METAL COMPLEXES AND THEIR USE AS THE EMITTING CONSTITUENT IN ELECTRONIC COMPONENTS, IN PARTICULAR IN ELECTROLUMINESCENT DISPLAY DEVICES
COMPLEXES METALLIQUES ET LEUR UTILISATION EN TANT QUE COMPOSANTS D'EMISSION DANS DES ELEMENTS ELECTRONIQUES, NOTAMMENT DANS DES DISPOSITIFS D'AFFICHAGE ELECTROLUMINESCENTS

(30) Priorität: 09.12.2004 EP 04029182
(43) Veröffentlichungstag der Anmeldung: 22.08.2007
(73) Patentinhaber: Merck Patent GmbH, 64293 Darmstadt (DE)
(72) Erfinder: STÖSSEL, Philipp, 60487 Frankfurt (DE); FORTTE, Rocco, 65933 Frankfurt (DE); PARHAM, Amir, 65929 Frankfurt (DE); VESTWEBER, Horst, 34630 Gilserberg (DE); HEIL, Holger, 64285 Darmstadt (DE)
(86) Internationale Anmeldenummer: PCT/EP2005/013044
(87) Internationale Veröffentlichungsnummer: WO 2006/061182

(56) Entgegenhaltungen:
- EP-A- 0 120 673
- EP-A- 0 525 739
- EP-A- 1 211 257
- EP-A- 1 348 711
- EP-A- 1 400 514
- WO-A-02/068435
- WO-A-03/040160
- BALDO M A ET AL: "Very high-efficiency green organic light-emitting devices based on electrophosphorescence" APPLIED PHYSICS LETTERS, AMERICAN INSTITUTE OF PHYSICS. NEW YORK, US, Bd. 75, Nr. 1, 5. Juli 1999 (1999-07-05), Seiten 4-6, XP012023409 ISSN: 0003-6951 in der Anmeldung erwähnt

## Beschreibung

Die vorliegende Erfindung beschreibt neue Materialien und Materialmischungen, deren Verwendung in Elektrolumineszenzelementen und darauf basierende Displays.

Metallorganische Verbindungen, speziell Verbindungen der d⁸-Metalle, werden in naher Zukunft in einer Reihe verschiedenartiger Anwendungen, die im weitesten Sinne der Elektronikindustrie zugerechnet werden können, Einsatz als funktionelle Materialien finden, z. B. in organischen Elektrolumineszenzvorrichtungen. Der allgemeine Aufbau solcher Vorrichtungen ist beispielsweise in US 4,539,507 und US 5,151,629 beschrieben. Üblicherweise besteht eine organische Elektrolumineszenzvorrichtung aus mehreren Schichten, die mittels Vakuummethoden oder Druckmethoden aufeinander aufgebracht werden. Bei den organischen Elektrolumineszenzvorrichtungen (OLEDs) ist die Markteinführung bereits erfolgt, wie die Autoradios der Firma Pioneer und die Mobiltelefone der Firmen Pioneer und SNMD mit "organischem Display" belegen. Weitere derartige Produkte stehen kurz vor der Einführung.

Eine Entwicklung, die sich in den letzten Jahren abzeichnet, ist der Einsatz metallorganischer Komplexe, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Ob sich diese Entwicklung durchsetzen wird, hängt davon ab, ob entsprechende Device-Kompositionen gefunden werden, die diese Vorteile (Triplett-Emission = Phosphoreszenz gegenüber Singulett-Emission = Fluoreszenz) auch in den OLEDs umsetzen können. Als wesentliche Bedingungen sind hier insbesondere eine hohe operative Lebensdauer und eine hohe thermische Stabilität zu nennen.

Allerdings gibt es bei OLEDs, die Triplettemission zeigen, immer noch erhebliche Probleme, die einer dringenden Verbesserung bedürfen. Dies gilt insbesondere auch für den Triplettemitter selbst. Aus der Literatur sind rote Emitter auf der Basis von Metallkomplexen bekannt (z. B. US 2003/0068526, WO 2003/000661), die an Iridium koordinierte 1-Phenylisochinolin-Liganden als Teilstrukturen gemäß Formel A und Formel B enthalten. Dabei unterscheiden sich die gezeigten Teilstrukturen durch die Abwesenheit (Formel A) bzw. Anwesenheit (Formel B) einer Brücke zwischen dem Phenyl- und dem Isochinolin-Ring, die 2 - 20 Alkylkohlenstoffatome enthält, die gegebenenfalls durch Heteroatome ersetzt sein können.

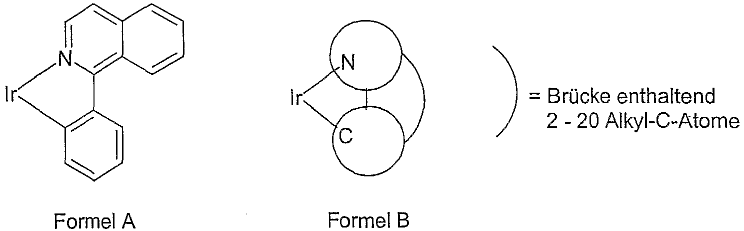

Verbindungen dieses Typs eignen sich als rote Emitter, weisen jedoch in der Praxis einige entscheidende Schwachpunkte auf, welche den technischen Einsatz dieser Verbindungen als unwahrscheinlich erscheinen lassen:
1. Ein entscheidender Mangel ist die geringe thermische Stabilität der oben beschriebenen Verbindungen. So kann zum Beispiel der homoleptische Komplex *fac*-Tris(1-phenyl-isochinolin-C²,N)iridium(III) (allgemein Ir(piq)₃ genannt) nicht unzersetzt sublimiert werden. Selbst unter typischen Hochvakuumbedingungen (p < 10⁻⁷ mbar) beobachtet man eine erhebliche Zersetzung dieser Verbindung, wobei neben einer iridiumhaltigen Asche, die ca. 30 Gew.% der eingesetzten Menge an Ir(piq)₃ ausmacht, die Freisetzung von 1-Phenylisochinolin und anderen niedermolekularen Verbindungen nachgewiesen werden kann. Diese thermische Zersetzung führt zu einer wenig reproduzierbaren Device-Charakteristik, wobei die Lebensdauer besonders negativ betroffen ist. Auch bei der Reinigung der Metallkomplexe durch Sublimation wäre es wünschenswert, temperaturstabilere Komplexe zur Verfügung zu haben, da die Zersetzung zu großen Verlusten der Komplexe führt.
2. Die operative Lebensdauer ist allgemein noch zu gering, was der Einführung von phosphoreszierenden OLEDs in hochwertigen und langlebigen Vorrichtungen entgegensteht.
3. Die Komplexe besitzen häufig nur eine geringe Löslichkeit in organischen Lösemitteln, was eine effiziente Reinigung durch Umkristallisation oder Chromatographie stark erschwert oder verhindert. Dies gilt insbesondere für die Reinigung größerer Mengen, wie sie in der Displayfertigung benötigt werden.
4. Die Komplexe sind - vor allem in Lösung - sehr oxidationsempfindlich. Gegebenenfalls müssen die Reinigung, die Lagerung, der Transport und die Verarbeitung dieser Verbindungen unter Inertgas erfolgen, was technisch sehr aufwändig ist und dadurch einen deutlichen Nachteil darstellt.
Besonders eine gleichzeitige Verbesserung der Lebensdauer und der thermischen Stabilität der Komplexe wäre vorteilhaft. Es besteht daher der Bedarf an Verbindungen, die die oben genannten Schwachpunkte nicht aufweisen, den bekannten Metallkomplexen jedoch in Bezug auf Effizienz und Emissionsfarbe mindestens gleichwertig sind.

Komplexe mit verbesserter thermischer Stabilität sind in WO 04/081017 beschrieben. Jedoch ist die Ligandensynthese dieser Komplexe sehr aufwändig, so dass Komplexe mit leichter zugänglichen Liganden und weiterhin guten elektro-optischen Eigenschaften und hoher thermischer Stabilität vorteilhaft wären.

Überraschend wurde nun gefunden, dass bestimmte neue Verbindungen, die statt des allgemein und auch in den oben abgebildeten Verbindungen verwendeten Fünfring-Chelates ein Sechsring-Chelat verwenden, ausgezeichnete Eigenschaften als Triplettemitter in OLEDs besitzen. Zur Erläuterung ist im Folgenden ein Iridium-Fünfring-Chelat und ein Iridium-Sechsring-Chelat abgebildet, wobei D ein koordinierendes Atom, beispielsweise Stickstoff, darstellt und C wie üblich für Kohlenstoff steht:

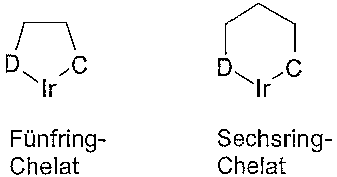

Metallkomplexe, die Sechsring- und Siebenring-Chelate für die Verwendung in OLEDs aufweisen, sind teilweise bereits in der Literatur beschrieben:
So werden in EP 1211257 Metallkomplexe beschrieben, die zwischen dem Phenyl- und dem Pyridinring eine nicht-konjugierte Einheit X enthalten, beispielsweise O, S, CR₂, etc., wodurch Sechsring-Chelat-Komplexe mit nicht durchgängig konjugierten Ligandensystemen entstehen. Diese Komplexe zeigen blaue bis orange-rote Emission, wie den Beispielen der oben,genannten Anmeldung zu entnehmen ist, sind aber offensichtlich nicht für die Erzeugung tiefroter Emission geeignet, was möglicherweise durch die fehlende Konjugation des Liganden zu begründen ist. Gerade jedoch an tiefrot emittierenden Verbindungen mit guten elektronischen Eigenschaften und hoher thermischer Stabilität besteht derzeit noch ein erheblicher Mangel. Außerdem wird für Leuchtdioden mit Verbindungen gemäß der zitierten Anmeldung eine sehr hohe Betriebsspannung benötigt. So wird für blaue Emission beispielsweise eine Spannung von 8 bis 12 V angegeben. Dies ist für die Anwendung ungeeignet und könnte wiederum in der fehlenden Konjugation der Liganden begründet sein. Es ist daher nicht ersichtlich, wie derartige Sechsring-Chelat-Strukturen nutzbringend eingesetzt werden könnten.
In JP 2003/342284 werden ähnliche Sechsring-Chelat-Komplexe beschrieben, wobei die Einheit X Teil eines größeren Ringsystems ist. Insbesondere ist X der Stickstoff eines Carbazol-Systems oder ein Kohlenstoff in 9-Position eines Fluorens. Hierbei entstehen wiederum Systeme, deren Liganden nicht konjugiert sind. Deshalb können hier dieselben Nachteile erwartet werden, wie oben bereits beschrieben.
In JP 2004/111193 werden konjugierte und nicht-konjugierte Siebenring-Chelat-Komplexe beschrieben.

Gegenstand der vorliegenden Erfindung sind die Verbindungen gemäß Formel (1)

M(L)ₙ(L')ₘ(L")ₒ Formel (1)

enthaltend eine Teilstruktur M(L)ₙ gemäß Formel (2a), 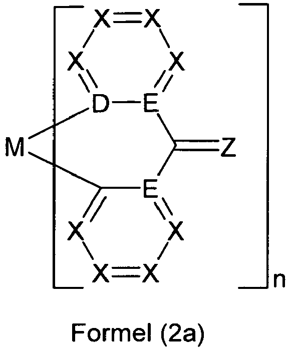 wobei für die verwendeten Symbole und Indizes gilt:
- M: ist bei jedem Auftreten Mo, W, Re, Ru, Os, Rh, Ir, Pd, Pt oder Au;
- D: ist gleich oder verschieden bei jedem Auftreten Stickstoff oder Phosphor;
- X: ist gleich oder verschieden bei jedem Auftreten CR¹, N oder P; oder
- (X-X) bzw. (X=X): (also zwei benachbarte X) steht für NR¹, S oder O, mit der Maßgabe, dass Cy1 und Cy2 jeweils einen Fünf- oder Sechsring bilden; oder
- (X-X) bzw. (X=X): (also zwei benachbarte X) steht für CR¹, N oder P, falls das Symbol E im entsprechenden Cyclus für N steht;
- E: ist gleich oder verschieden bei jedem Auftreten C oder N mit der Maßgabe, dass, falls das Symbol E für N steht, genau eine Einheit X-X (also zwei benachbarte X) im entsprechenden Cyclus gleich CR¹, N oder P ist; der Cyclus bildet dann also einen Fünfring;
- Z: ist gleich oder verschieden bei jedem Auftreten C(R)₂ oder NR;
- Cy1: ist gleich oder verschieden bei jedem Auftreten ein Homo- oder Heterocyclus, der über ein sp²-hybridisiertes Kohlenstoffatom an M bindet und der gegebenenfalls eine Bindung zur Gruppe R aufweist;
- Cy2: ist gleich oder verschieden bei jedem Auftreten ein Heterocyclus, der über das Atom D an M koordiniert und der gegebenenfalls eine Bindung zur Gruppe R aufweist;
- R: ist gleich oder verschieden bei jedem Auftreten H, F, CN, eine geradkettige Alkyl-oder Alkoxygruppe mit 1 bis 40 C-Atomen oder eine verzweigte oder cyclische Alkyl-oder Alkoxygruppe mit 3 bis 40 C-Atomen, wobei jeweils eine oder mehrere nicht benachbarte CH₂-Gruppen durch -R²C=CR²-, -C≡C-, Si(R²)₂, Ge(R²)₂, Sn(R²)₂, -O-, -S-, -NR²-, -(C=O)-, -(C=NR²)-, -P=O(R²)-, SO, SO₂ oder -CONR²- ersetzt sein können und wobei ein oder mehrere H-Atome durch F ersetzt sein können, oder ein aromatisches oder heteroaromatisches Ringsystem bzw. eine Aryloxy- oder Heteroaryloxygruppe mit 5 bis 40 aromatischen Ringatomen, welches durch einen oder mehrere nicht-aromatische Reste R substituiert sein kann, oder eine Kombination aus zwei, drei oder vier dieser Systeme; dabei kann R auch ein Ringsystem mit X bzw. mit R¹ bilden ;
- R¹: ist gleich oder verschieden bei jedem Auftreten H, F, Cl, Br, I, OH, NO₂, CN, N(R²)₂, eine geradkettige Alkyl-, Alkoxy- oder Thioalkolxygruppe mit 1 bis 40 C-Atomen oder eine verzweigte oder cyclische Alkyl-, Alkoxy- oder Thioalkoxygruppe mit 3 bis 40 C-Atomen, wobei eine oder mehrere nicht benachbarte CH₂-Gruppen durch -R²C=CR²-, -C≡C-, Si(R²)₂, Ge(R²)₂, Sn(R²)₂, -O-, -S-, -NR²-, -(C=O)-, -(C=NR¹)-, -P=O(R²)-, SO, SO₂, -COOR²- oder -CONR²- ersetzt sein können und wobei ein oder mehrere H-Atome durch F, Cl, Br, I oder CN ersetzt sein können, oder ein aromatisches oder heteroaromatisches Ringsystem bzw. eine Aryloxy- oder Heteroaryloxygruppe mit 5 bis 40 aromatischen Ringatomen, welches durch einen oder mehrere nicht-aromatische Reste R¹ substituiert sein kann, oder eine Kombination aus zwei, drei oder vier dieser Systeme; dabei können mehrere Substituenten R¹, sowohl am selben Ring als auch an unterschiedlichen Ringen zusammen, oder auch R¹ und R und/oder R² wiederum ein weiteres mono- oder polycyclisches, aliphatisches, aromatisches oder heteroaromatisches Ringsystem aufspannen;
- R²: ist gleich oder verschieden bei jedem Auftreten H oder ein aliphatischer oder aromatischer Kohlenwasserstoffrest mit 1 bis 30 C-Atomen;
- n: ist 1, 2 oder 3;
dabei sind die Liganden L' und L" in Formel (1) monoanionische, zweizähnig chelatisierende Liganden; m und o sind gleich oder verschieden bei jedem Auftreten 0, 1 oder 2; und n + m + o = 2 oder 3.

Unter Hybridisierung wird die Linearkombination von Atomorbitalen verstanden. So entstehen durch Linearkombination von einem 2s- und zwei 2p-Orbitalen drei äquivalente sp²-Hybridorbitale, die einen Winkel von 120° miteinander bilden. Das verbleibende p-Orbital ist dann zur Ausbildung einer π-Bindung, beispielsweise in einem aromatischen System, befähigt.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 40 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Eine besonders bevorzugte Ausführungsform der vorliegenden Erfindung sind Verbindungen der Formel (1 a),

M(L)ₙ(L')ₘ(L")ₒ Formel (1a)

enthaltend mindestens eine Teilstruktur M(L)ₙ der Formel (2b), gleich oder verschieden bei jedem Auftreten, 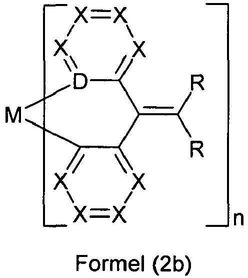 und gegebenenfalls enthaltend eine Teilstruktur M(L')ₘ der Formel (3), gleich oder verschieden bei jedem Auftreten, 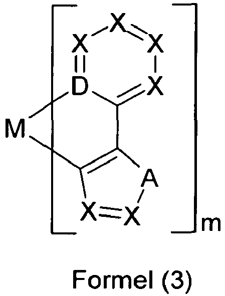 wobei M, D, R, R¹, R², L", n, m und o dieselbe Bedeutung haben, wie oben beschrieben, und weiterhin gilt:
- X: ist gleich oder verschieden bei jedem Auftreten CR¹, N oder P; oder
- (X-X) bzw. (X=X): (also zwei benachbarte X) steht für NR¹, S oder O, mit der Maßgabe, dass Cy1 und Cy2 jeweils einen Fünf- oder Sechsring bilden;
- A: ist gleich oder verschieden bei jedem Auftreten -CR¹=CR¹-, -N=CR¹-, -P=CR¹-, -N=N-, -P=N-, NR¹, PR¹, O, S oder Se.

Ganz besonders bevorzugt sind Verbindungen gemäß Formel (1) bzw. Formel (1 a), enthaltend eine Teilstruktur M(L)ₙ gemäß Formel (2c), gemäß Formel (2d) oder gemäß Formel (2e), 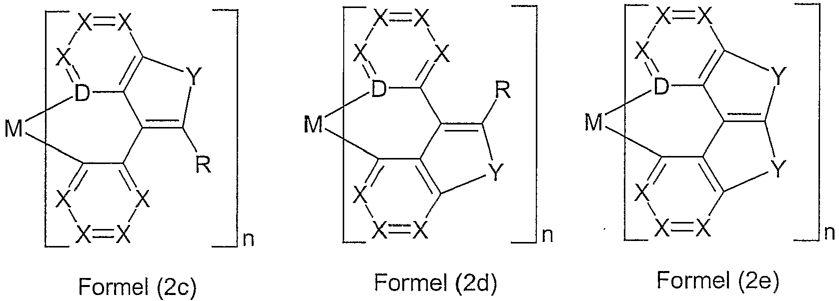 wobei M, X, D, R, R¹, R² und n dieselbe Bedeutung haben, wie oben beschrieben, und für das Symbol Y gilt:
- Y: ist bei jedem Auftreten gleich oder verschieden eine bivalente Gruppe, ausgewählt aus -C(R¹)₂-, -C(=O)-, -C[=C(R¹)₂]-, -C(R¹)₂-C(R¹)₂-, -C(=O)-O-, -C(=O)-N(R¹)-, -C(R¹)₂-C(R¹)₂-C(R¹)₂-, -C(R¹)₂-O-C(R¹)₂-, -C(R¹)₂-N(R¹)-, -C(R¹)=C(R¹)-, -C(R¹)=N-, -O-, -S-, -N(R¹)-, -P(R¹)-, -P(=O)(R¹)- und -B(R¹)-.

Erfindungsgemäße monoanionische, zweizähnige Liganden L" sind 1,3-Diketonate abgeleitet von 1,3-Diketonen, wie z. B. Acetylaceton, Benzoylaceton, 1,5-Diphenylacetylaceton, Bis(1,1,1-trifluoracetyl)methan, 3-Ketonate abgeleitet von 3-Ketoestern, wie z. B. Acetessigsäureethylester, Carboxylate abgeleitet von Aminocarbonsäuren, wie z. B. Pyridin-2-carbonsäure, Chinolin-2-carbonsäure, Glycin, N,N-Dimethylglycin, Alanin, N,N-Dimethylalanin, Salicyliminate abgeleitet von Salicyliminen, wie z. B. Methylsalicylimin, Ethylsalicylimin, Phenylsalicylimin, sowie Borate Stickstoff-haltiger Heterocyclen, wie z. B. Tetrakis(1-imidazolyl)borat und Tetrakis(1-pyrazolyl)borat.

Die Liganden L sind entweder konjugierte oder gekreuzt-konjugierte Systeme. Dabei werden konjugierte Systeme erzeugt, wenn mindestens einer der Substituenten R mit dem Cyclus Cy1 und/oder Cy2 ein aromatisches Ringsystem bildet. Dagegen werden gekreuzt-konjugierte Systeme erzeugt, wenn keiner der Substituenten R mit Cy1 oder Cy2 ein aromatisches Ringsystem bilden, wenn also R entweder ein aliphatisches oder überhaupt kein Ringsystem mit Cy1 oder Cy2 bildet.

In einer besonders bevorzugten Ausführungsform der Erfindung handelt es sich um steife Systeme, also um Systeme, in denen beide Substituenten R mit dem Cyclus Cy1 und dem Cy2 einen Fünfring oder einen Sechsring gemäß Formel (2e) bilden.

In einer weiteren besonders bevorzugten Ausführungsform der Erfindung ist der Ligand so aufgebaut und substituiert, dass sich daraus bei Koordination an ein Metall kein Fünfring-Chelat bilden kann.

Bevorzugt sind weiterhin Verbindungen gemäß Formel (1) bzw. Formel (1a), bei denen für das Symbol M = Rh, Ir, Pd oder Pt gilt; besonders bevorzugt gilt M = Ir oder Pt, ganz besonders bevorzugt ist M = Ir.

Bevorzugt sind weiterhin Verbindungen gemäß Formel (1) bzw. Formel (1a), bei denen für das Symbol n = 2 oder 3 gilt. Besonders bevorzugt sind Verbindungen, bei denen für das Symbol o = 0 gilt. Ganz besonders bevorzugt sind Verbindungen, bei denen für die Symbole m = o = 0 gilt. Dabei gilt insbesondere, dass n = 2 und m = o = 0 für Palladium- und Platin-Komplexe und andere quadratisch-planar koordinierte Metalle und n = 3 und m = o = 0 für Rhodium- und Iridium-Komplexe und andere oktaedrisch koordinierte Metalle bevorzugt ist.

Bevorzugt sind weiterhin Verbindungen gemäß Formel (1) bzw. Formel (1 a), bei denen für das Symbol Z = C(R)₂ gilt.

Bevorzugt sind weiterhin Verbindungen gemäß Formel (1) bzw. Formel (1 a), bei denen für das Symbol D = N gilt.

Bevorzugt sind weiterhin Verbindungen gemäß Formel (1) bzw. Formel (1 a), bei denen für das Symbol X = CR¹ oder N gilt, insbesondere X = CR¹.

Bevorzugt sind die erfindungsgemäßen Verbindungen gemäß Formel (1) bzw. Formel (1a), bei denen das Symbol Y in Formel (2c), (2d) bzw. (2e) für eine bivalente Gruppe, ausgewählt aus -C(R¹)₂-, -C(=O)-, -C(R¹)₂-C(R¹)₂-, -C(R¹)₂-N(R¹)-, -C(R¹)=C(R¹)-, -C(R¹)=N-, -O-, -S- und -N(R¹)-, steht. Besonders bevorzugt steht das Symbol Y für -C(R¹)₂-, -C(R¹)₂-C(R¹)₂-, -C(R¹)=C(R¹)-, -S- oder -N(R¹)-.

In einer weiteren bevorzugten Ausführungsform der Erfindung können zwei oder drei Liganden L und/oder L' und/oder L" über die Reste R¹ zu einem polypodalen System bzw. zu einem Kryptanden verknüpft sein. Dabei kann die Verknüpfung sowohl an Cy1 wie auch an Cy2 erfolgen.

Die entsprechenden Liganden, die Teilstrukturen gemäß Formel (2) bzw. Formel (2a) bis (2e) erzeugen, bzw. auch die Liganden L' und L" können nach gängigen organischchemischen Verfahren dargestellt werden, wie sie dem Fachmann der organischen Synthese geläufig sind. Dabei bieten sich für die Ligandensynthese vollständig überbrückter Systeme, also Systeme, in denen zwei Gruppen Y gemäß Formel (2e) vorhanden sind, Reaktionen in Analogie zur Literatur an (z. B. A.-S. Rebstock et al., Tetrahedron 2003, 59, 4973-4977; R. G. Harvey et al., J. Org. Chem. 2000, 65, 3952-3960).

Die erfindungsgemäßen Metallkomplexe sind prinzipiell durch verschiedene Verfahren darstellbar; es haben sich jedoch die im Folgenden beschriebenen Verfahren als besonders gut geeignet herausgestellt.

Daher ist ein weiterer Gegenstand der vorliegenden Erfindung ein Verfahren zur Herstellung der Metallkomplex-Verbindungen durch Umsetzung der entsprechenden freien Liganden mit Metallalkoholaten der Formel (4), mit Metallketoketonaten der Formel (5) oder ein- oder mehrkernigen Metallhalogeniden der Formel (6), (7) oder (8), 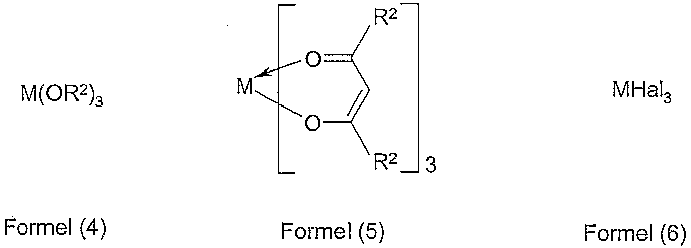 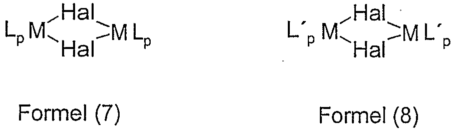 wobei die Symbole M und R² die oben angegebenen Bedeutungen haben, p = 1 oder 2 und Hal = F, Cl, Br oder I ist.

Es können weiterhin besonders bevorzugt Metallverbindungen, bevorzugt Rhodium- und Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 04/085449 offenbart, beispielsweise Na[Ir(acac)₂Cl₂].

Die Synthese der Komplexe wird bevorzugt durchgeführt, wie in WO 02/060910 und in WO 04/085449 beschrieben. Heteroleptische Komplexe können beispielsweise auch gemäß WO 05/042548 synthetisiert werden.

Durch diese Verfahren lassen sich die erfindungsgemäßen Verbindungen gemäß Formel (1) in hoher Reinheit, bevorzugt mehr als 99 % (bestimmt mittels ¹H-NMR und/oder HPLC) erhalten.

Mit den hier erläuterten Synthesemethoden lassen sich unter anderem die im Folgenden dargestellten Strukturen (1) bis (141) für die Verbindungen gemäß Formel (1) herstellen, die noch durch Substituenten R¹ substituiert sein können. Diese Substituenten sind hier in einigen Fällen der Übersichtlichkeit halber nicht abgebildet.

| | | |
|---|---|---|
| 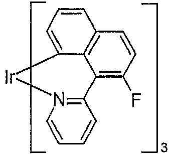 | 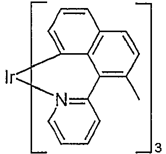 | 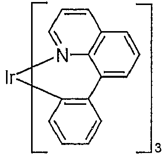 |
| (1) | (2) | (3) |
| 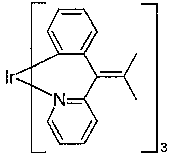 | 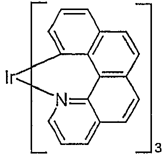 | 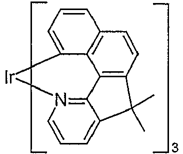 |
| (4) | (5) | (6) |
| 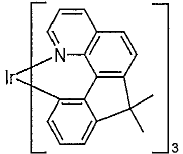 | 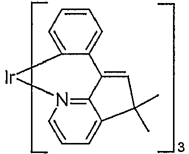 | 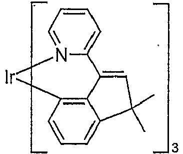 |
| (7) | (8) | (9) |
| 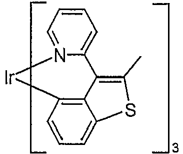 | 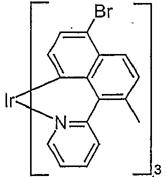 | 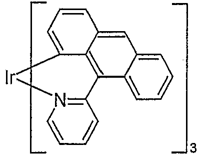 |
| (10) | (11) | (12) |
| 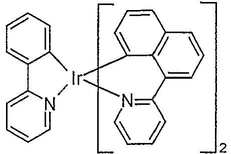 | 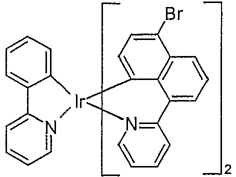 | 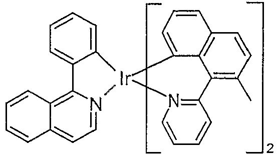 |
| (13) | (14) | (15) |
| 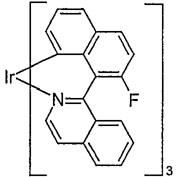 | 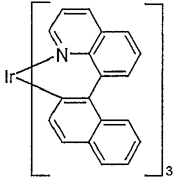 | 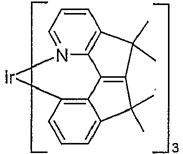 |
| (16) | (17) | (18) |
| 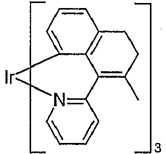 | 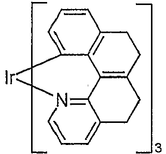 | 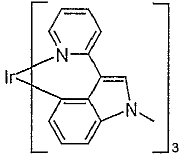 |
| (19) | (20) | (21) |
| 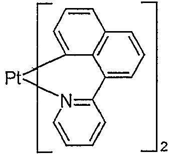 | 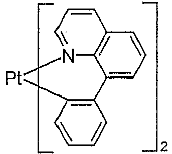 | 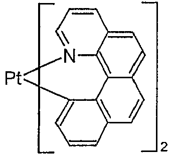 |
| (22) | (23) | (24) |
| 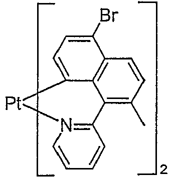 | 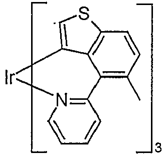 | 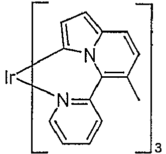 |
| (25) | (26) | (27) |
| 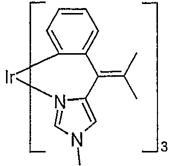 | 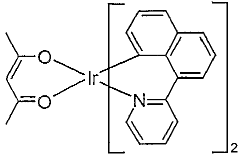 | 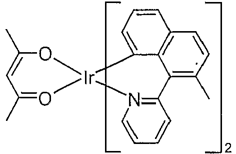 |
| (28) | (29) | (30) |
| 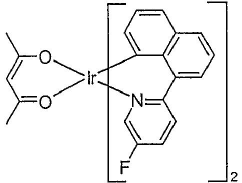 | 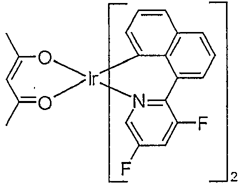 | 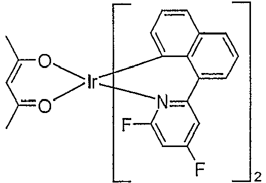 |
| (31) | (32) | (33) |
| 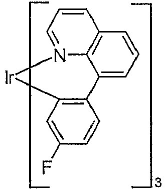 | 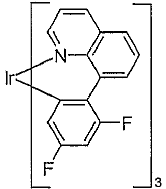 | 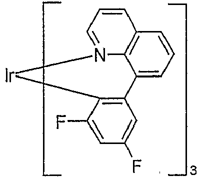 |
| (34) | (35) | (36) |
| 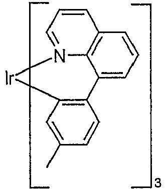 | 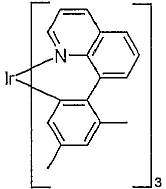 | 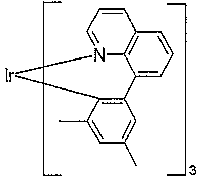 |
| (37) | (38) | (39) |
| 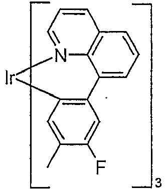 | 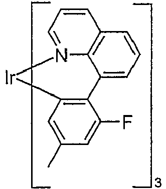 | 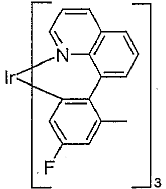 |
| (40) | (41) | (42) |
| 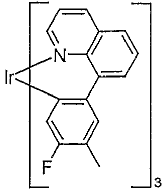 | 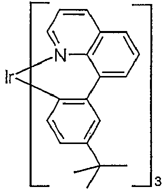 | 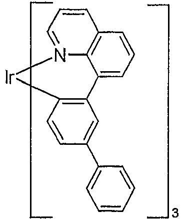 |
| (43) | (44) | (45) |
| 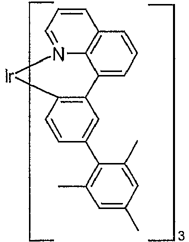 | 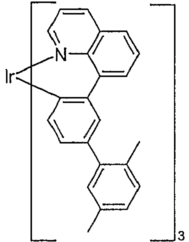 | 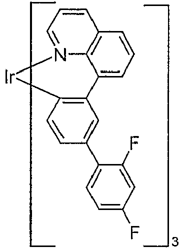 |
| (46) | (46) | (47) |
| 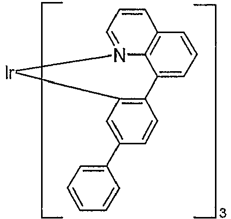 | 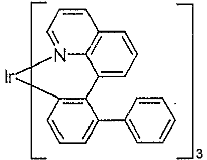 | 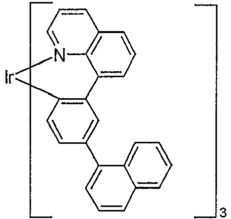 |
| (48) | (49) | (50) |
| 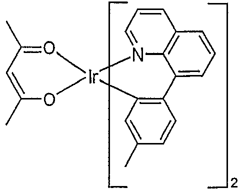 | 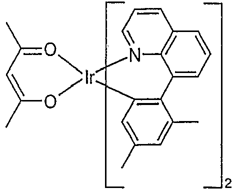 | 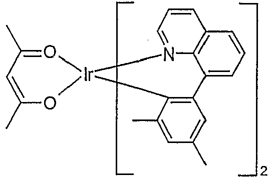 |
| (51) | (52) | (53) |
| 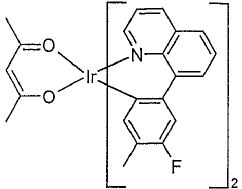 | 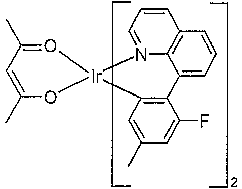 | 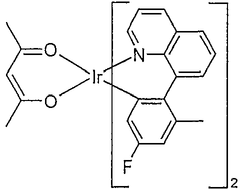 |
| (54) | (55) | (56) |
| 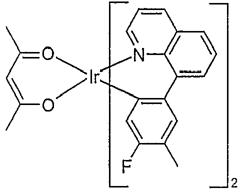 | 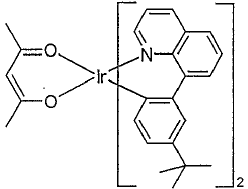 | 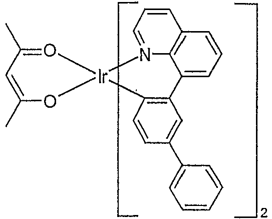 |
| (57) | (58) | (59) |
| 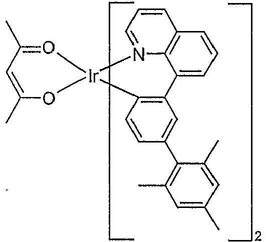 | 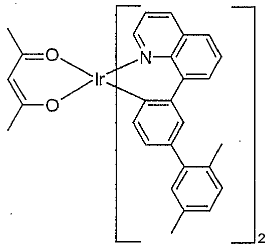 | 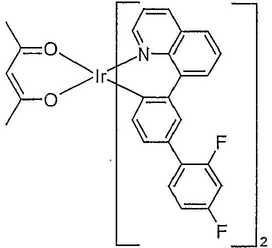 |
| (60) | (61) | (62) |
| 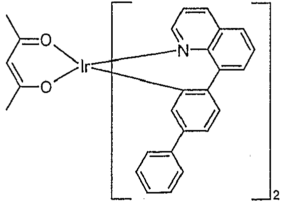 | 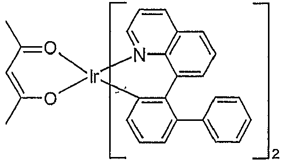 | 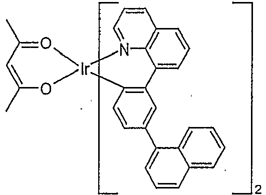 |
| (64) | (65) | (66) |
| 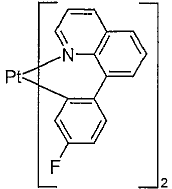 | 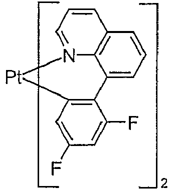 | 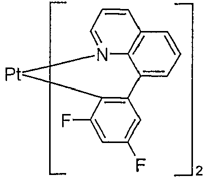 |
| (67) | (68) | (69) |
| 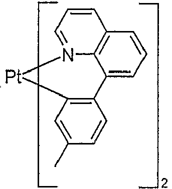 | 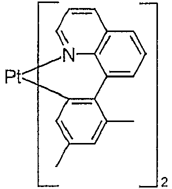 | 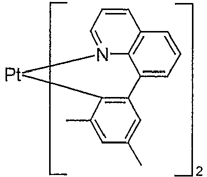 |
| (70) | (71) | (72) |
| 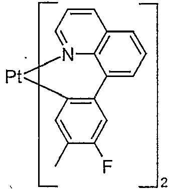 | 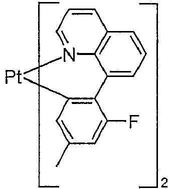 | 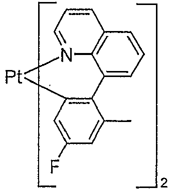 |
| (73) | (74) | (75) |
| 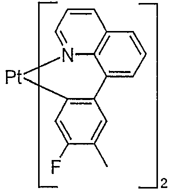 | 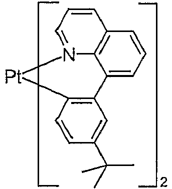 | 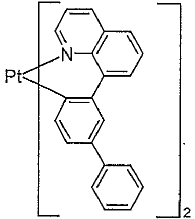 |
| (76) | (77) | (78) |
| 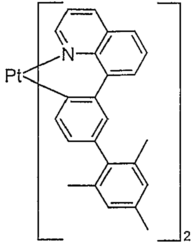 | 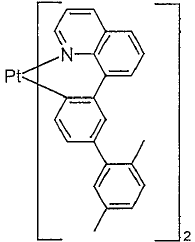 | 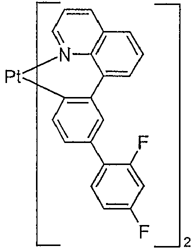 |
| (79) | (80) | (81) |
| 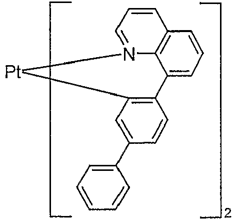 | 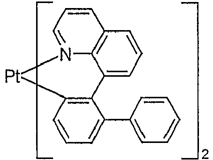 | 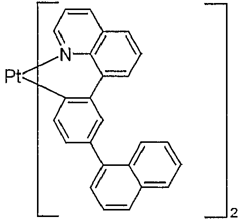 |
| (82) | (83) | (84) |
| 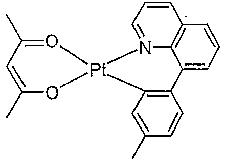 | 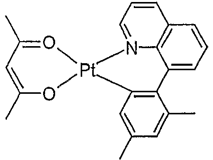 | 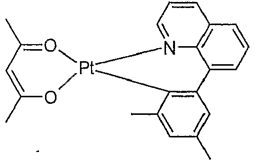 |
| (85) | (86) | (87) |
| 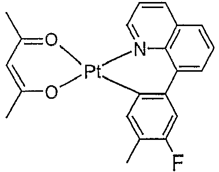 | 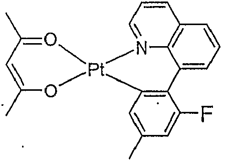 | 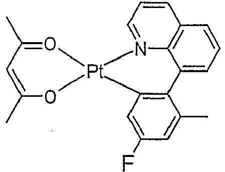 |
| (88) | (89) | (90) |
| 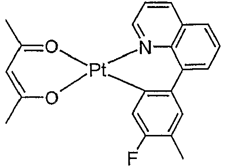 | 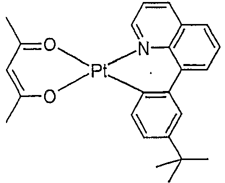 | 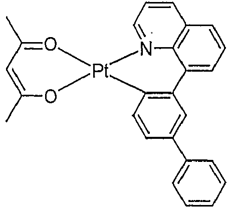 |
| (91) | (92) | (93) |
| 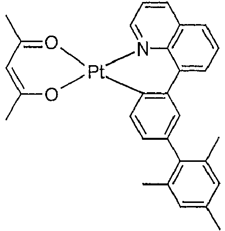 | 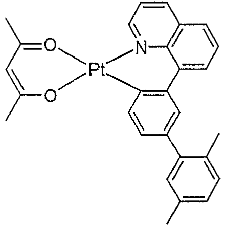 | 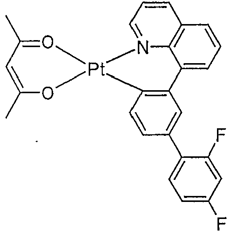 |
| (94) | (95) | (96) |
| 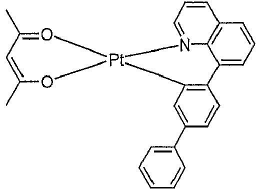 | 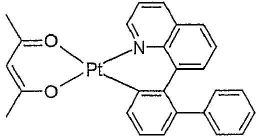 | 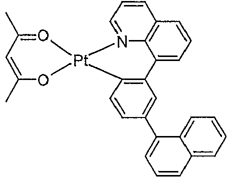 |
| (97) | (98) | (99) |
| 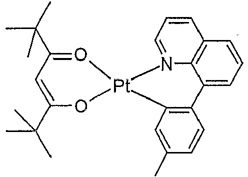 | 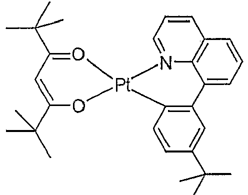 | 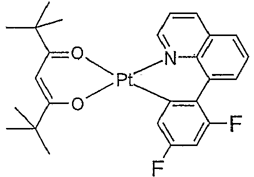 |
| (100) | (101) | (102) |
| 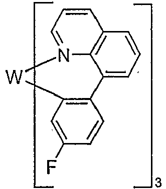 | 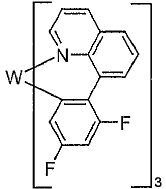 | 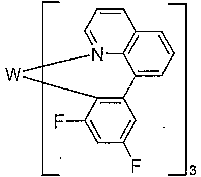 |
| (103) | (104) | (105) |
| 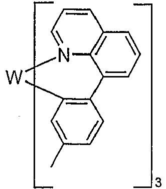 | 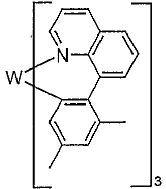 | 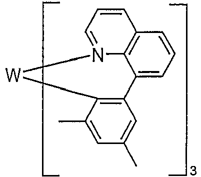 |
| (106) | (107) | (108) |
| 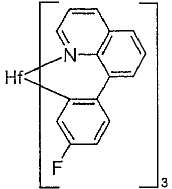 | 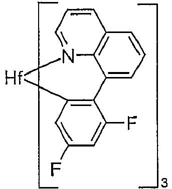 | 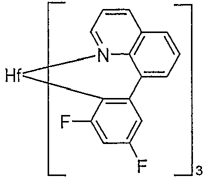 |
| (109) | (110) | (111) |
| 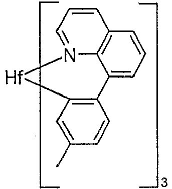 | 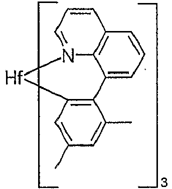 | 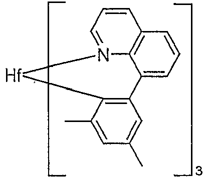 |
| (112) | (113) | (114) |
| 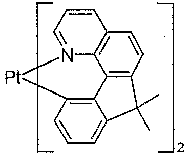 | 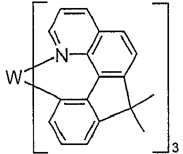 | 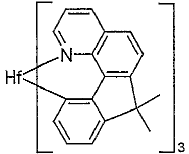 |
| (115) | (116) | (117) |
| 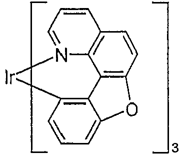 | 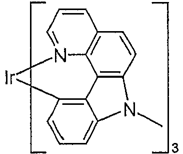 | 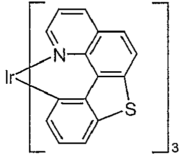 |
| (118) | (119) | (120) |
| 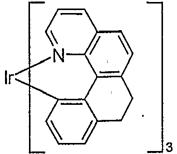 | 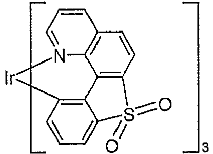 | 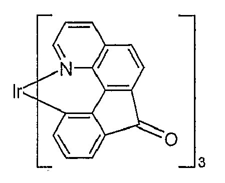 |
| (121) | (122) | (123) |
| 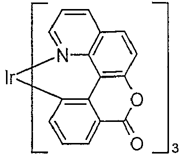 | 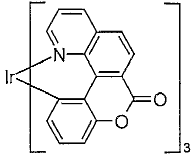 | 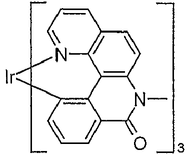 |
| (124) | (125) | (126) |
| 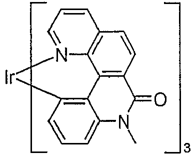 | 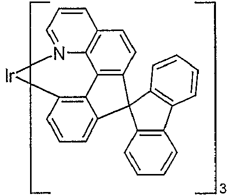 | 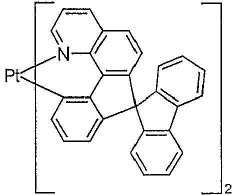 |
| (127) | (128) | (129) |
| 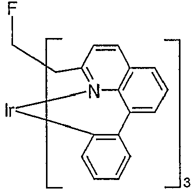 | 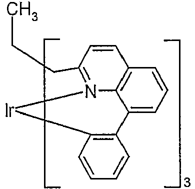 | 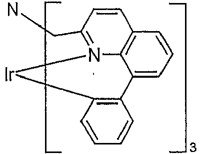 |
| (130) | (131) | (132) |
| 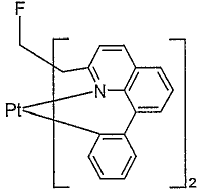 | 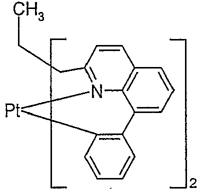 | 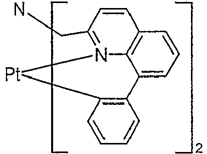 |
| (133) | (134) | (135) |
| 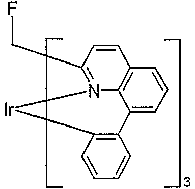 | 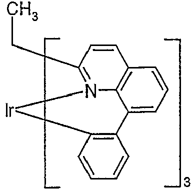 | 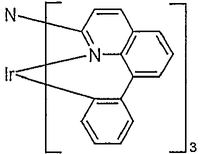 |
| (136) | (137) | (138) |
| 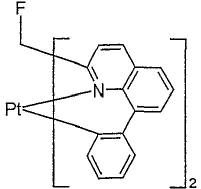 | 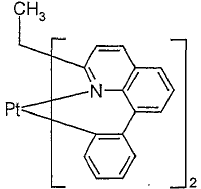 | 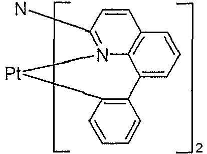 |
| (139) | (140) | (141) |

Die oben beschriebenen erfindungsgemäßen Verbindungen, z. B. Verbindungen gemäß den Strukturen (11), (14) und (25), können auch als Comonomere zur Erzeugung entsprechender konjugierter, teilkonjugierter oder nicht-konjugierter Oligomere, Polymere oder Dendrimere Verwendung finden. Die Polymerisation erfolgt dabei bevorzugt über die Bromfunktionalität. So können sie u. a. in Polyfluorene (z. B. gemäß EP 842208 oder WO 00/22026), Poly-spirobifluorene (z. B. gemäß EP 707020 oder EP 894107), Poly-paraphenylene (z. B. gemäß WO 92/18552), Poly-dihydrophenanthrene (z. B. gemäß WO 05/014689), Poly-phenanthrene (z. B. gemäß der nicht offen gelegten Anmeldung DE 102004020298.2), Poly-indenofluorene (z. B. gemäß WO 04/041901 und WO 04/113412), Polycarbazole (z. B. gemäß WO 04/070772 oder WO 04/113468), Polyketone (z. B. gemäß WO 05/040302), Polysilane (z. B. gemäß DE 102004023278.4) oder Polythiophene (z. B. gemäß EP 1028136) einpolymerisiert werden oder auch in Copolymere, die verschiedene dieser Einheiten enthalten. Dabei können sie entweder in die Seitenkette oder in die Hauptkette des Polymers eingebaut werden oder können auch Verzweigungspunkte der Polymerketten (z. B. gemäß DE 102004032527.8) oder Endgruppen der Polymerkette darstellen.

Weiterer Gegenstand der Erfindung ist daher die Verwendung Verbindungen gemäß Formel (1) bzw. gemäß Formel (1 a), in denen mindestens einer der Substituenten R¹ eine Gruppe darstellt, die zu einer C-C-Kupplungsreaktion unter Palladium- oder Nickelkatalyse befähigt ist, zur Synthese konjugierter, teilkonjugierter oder nicht-konjugierter Polymere, Oligomere oder Dendrimere. Bevorzugt ist der Substituent, der zu einer C-C-Kupplungsreaktion befähigt ist, ausgewählt aus der Gruppe bestehend aus Cl, Br, I, O-Tosylat, O-Triflat, O-SO₂R², B(OR²)₂ und Sn(R²)₃, besonders bevorzugt aus Br, O-Triflat und B(OR²)₂, wobei R² dieselbe Bedeutung hat, wie oben beschrieben, und wobei zwei oder mehr Reste R² auch miteinander ein Ringsystem bilden können. Weiterhin bevorzugt ist diese Gruppe an den Cyclus Cy1 gebunden, besonders bevorzugt in para-Position zur Bindung an das Metall M. Diese Metallkomplexe, die als Monomere für die Polymerisation eingesetzt werden können, sind ebenfalls eine bevorzugte Ausführungsform der vorliegenden Erfindung.

Abhängig davon, ob diese zur C-C-Kupplungsreaktion befähigte Gruppe nur einmal, zweimal oder dreimal oder öfter im Komplex vorhanden ist, stellt der Komplex eine Endgruppe im Polymer dar, oder er wird linear in die Polymerkette eingebaut, oder er stellt einen Verzweigungspunkt der Polymerkette dar. Weiterhin kann der Komplex auch bei geeigneter Substitution eine Seitenkette einer linearen oder verzweigten Polymerkette darstellen.

Weiterer Gegenstand der Erfindung sind somit konjugierte, teilkonjugierte oder nicht-konjugierte Oligomere, Polymere oder Dendrimere, enthaltend eine oder mehrere der Verbindungen gemäß Formel (1) bzw. Formel (1a), wobei mindestens einer der oben definierten Reste R bzw. R¹, bevorzugt R¹, eine Bindung zum Oligomer, Polymer oder Dendrimer darstellt. Für Einheiten gemäß Formel (1) bzw. Formel (1 a) gelten in Polymeren und Dendrimeren dieselben Bevorzugungen, wie oben bereits beschrieben.

Die oben genannten Oligomere, Polymere, Copolymere und Dendrimere zeichnen sich durch ihre gute Löslichkeit in organischen Lösemitteln und hohe Effizienz und Stabilität in organischen elektrolumineszierenden Vorrichtungen aus. Weiterhin sind diese Oligomere, Polymere und Dendrimere thermisch sehr stabil.

Weiterhin können die erfindungsgemäßen Verbindungen gemäß Formel (1), insbesondere solche, die durch Halogene funktionalisiert sind, auch durch gängige Reaktionstypen weiter funktionalisiert werden und so zu erweiterten Verbindungen gemäß Formel (1) umgesetzt werden. Hier ist als Beispiel die Funktionalisierung mit Arylboronsäuren gemäß Suzuki oder mit Aminen gemäß Hartwig-Buchwald zu nennen.

Die erfindungsgemäßen Verbindungen, Oligomere, Polymere, Dendrimere oder erweiterten Verbindungen gemäß Formel (1) finden Verwendung als aktive Komponenten in elektronischen Bauteilen, wie z. B. organischen Leuchtdioden (OLEDs), organischen integrierten Schaltungen (O-ICs), organischen Feld-Effekt-Transistoren (O-FETs), organischen Dünnfilmtransistoren (O-TFTs), organischen Solarzellen (O-SCs), organischen lichtemittierenden Transistoren (O-LETs), organischen Feld-Quench-Devices (O-FQDs), lichtemittierenden elektrochemischen Zellen (LECs) oder organischen Laserdioden (O-Laser).

Gegenstand der vorliegenden Erfindung ist also weiterhin die Verwendung der erfindungsgemäßen Verbindungen gemäß Formel (1), der erfindungsgemäßen Oligomere, Polymere und Dendrimere und entsprechender erweiterter Verbindungen gemäß Formel (1) als aktive Komponente in elektronischen Bauteilen, insbesondere als emittierende Verbindung.

Weiterer Gegenstand der Erfindung sind elektronische Bauteile, insbesondere organische und polymere Leuchtdioden (OLEDs, PLEDs), organische Feld-Effekt-Transistoren (O-FETs), organische Dünnfilmtransistoren (O-TFTs), organische integrierte Schaltungen (O-ICs), organische Solarzellen (O-SCs), organische lichtemittierende Transistoren (O-LETs), organische Feld-Quench-Devices (O-FQDs), lichtemittierende elektrochemische Zellen (LECs) und organische Laserdioden (O-Laser), enthaltend eine oder mehrere erfindungsgemäße Verbindungen gemäß Formel (1), erfindungsgemäße Oligomere, Polymere und Dendrimere und entsprechende erweiterte Verbindungen gemäß Formel (1), insbesondere als emittierende Verbindung.

Bevorzugt werden die erfindungsgemäßen Verbindungen als emittierende Verbindungen in einer emittierenden Schicht in einer organischen oder polymeren Leuchtdiode eingesetzt. Insbesondere wenn es sich um niedermolekulare erfindungsgemäße Verbindungen handelt, werden diese üblicherweise zusammen mit einem Matrix-Material eingesetzt. Dabei kann das Matrixmaterial sowohl niedermolekular, wie auch oligomer oder polymer sein.

Bevorzugte Matrixmaterialien sind solche auf Basis von Carbazolen, beispielsweise CBP (Bis(carbazolyl)biphenyl), aber auch andere Materialien enthaltend Carbazol oder Carbazol-Derivate, z. B. gemäß WO 00/057676, EP 01/202358 und WO 02/074015. Bevorzugt sind weiterhin Ketone und Imine, wie beispielsweise in WO 04/093207 beschrieben, insbesondere solche, basierend auf Spirobifluoren, und Phosphinoxide, Phosphinselenide, Phosphazene, Sulfoxide und Sulfone, wie beispielsweise in WO 05/003253 beschrieben, insbesondere solche, basierend auf Spirobifluoren. Weiterhin bevorzugt sind Silane, polypodale Metallkomplexe, z. B. gemäß WO 04/081017 und Oligophenylene basierend auf Spirobifluorenen, z. B. gemäß EP 676461 und WO 99/40051. Besonders bevorzugte Matrixmaterialien sind Ketone, Phosphinoxide, Sulfoxide und Sulfone. Ganz besonders bevorzugt sind Ketone und Phosphinoxide.

Die erfindungsgemäßen Verbindungen weisen die folgenden Vorteile gegenüber Verbindungen gemäß dem Stand der Technik auf:
1. Die erfindungsgemäßen Verbindungen zeichnen sich durch eine hohe Temperaturstabilität aus. So können die niedermolekularen Verbindungen im Hochvakuum unzersetzt verdampft werden, und auch die oligomeren, dendritischen und polymeren Verbindungen sind thermisch sehr stabil, so dass die Vorrichtungen ohne Schaden thermisch behandelt werden können. Diese Eigenschaft ist eine Grundvoraussetzung zur reproduzierbaren Darstellung von OLEDs und wirkt sich insbesondere positiv auf die operative Lebensdauer aus. Weiterhin ist so die ressourcenschonende Nutzung von Verbindungen dieser seltenen Metalle möglich, da die Komplexe bei der Reinigung und Device-Herstellung nahezu verlustfrei sublimiert werden können.
2. Die erfindungsgemäßen Verbindungen zeichnen sich durch eine gute Löslichkeit in organischen Lösungsmitteln aus, was ihre Reinigung durch gängige Verfahren wie Umkristallisation oder Chromatographie erheblich erleichtert. Damit sind die Verbindungen auch aus Lösung durch Beschichtungs- oder Drucktechniken verarbeitbar. Auch bei der üblichen Verarbeitung durch Verdampfen ist diese Eigenschaft von Vorteil, da so die Reinigung der Anlagen bzw. der eingesetzten Schattenmasken erheblich erleichtert wird.
3. Die erfindungsgemäßen Verbindungen zeichnen sich durch eine verbesserte Oxidationsstabilität aus, was sich positiv auf die Reinigung und generell auf die Handhabung dieser Verbindungen auswirkt.
4. Die erfindungsgemäßen Verbindungen sind reproduzierbar in hoher Reinheit herstellbar und weisen keine Chargenschwankung auf. Ein industrieller Prozess zur Herstellung der erfindungsgemäßen Elektrolumineszenzvorrichtungen ist daher wesentlich effizienter.
5. Die Ligandensynthese ist einfacher und umfasst weniger Schritte als die Synthese der Liganden in WO 04/081017. Dies ist ein deutlicher technischer Vorteil.

Die vorliegende Erfindung wird durch die folgenden Beispiele näher erläutert, ohne sie darauf beschränken zu wollen. Der Fachmann kann aus den Schilderungen ohne erfinderisches Zutun weitere erfindungsgemäße Verbindungen herstellen bzw. diese in organischen elektronischen Vorrichtungen verwenden.

### Beispiele:

Die nachfolgenden Synthesen werden, sofern nicht anders angegeben, unter einer Schutzgasatmosphäre durchgeführt. Die Edukte können von den Firmen ALDRICH bzw. ABCR bezogen werden. Die Synthese von 2,7-Dibrom-9,9-dimethylfluoren kann gemäß EP 1298117, die von 8-Chinolinyltrifluormethansulfonat gemäß Organometallics 2005, 24(6), 1329 und die von Na[Ir(acac)₂Cl₂] gemäß WO 04/085449 durchgeführt werden.

### Beispiel 1: (1,3-Pentandionato-κO,κO')bis[2-(8-chinolinyl-κN)phenyl-κC]iridium(III) (Ir1)

### a) Synthese von 8-Phenylchinolin

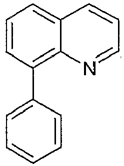

Eine gut gerührte Suspension von 13.9 g (50 mmol) 8-Chinolinyltrifluormethan-sulfonat, 12.2 g (100 mmol) Benzolboronsäure, 8.5 g (200 mmol) Lithiumchlorid, 8.0 g (75 mmol) Natriumcarbonat in einem Gemisch aus 200 ml Toluol, 50 ml Dioxan und 50 ml Wasser wird mit 1.7 g (1.5 mmol) Tetrakistriphenylphosphinopalladium(0) versetzt und 16 h unter Rückfluss erhitzt. Nach Erkalten wird die wässrige Phase abgetrennt, die organische Phase wird dreimal mit 200 ml Wasser gewaschen, über Magnesiumsulfat getrocknet und zur Trockene eingeengt. Das verbliebene Öl wird zweimal aus Ethanol (5 ml / g) umkristallisiert. Die Ausbeute bei einer Reinheit von 99.0 % n. ¹H-NMR beträgt 8.6 g (42 mmol), entsprechend 83.8 % d. Th..
¹H-NMR (CDCl₃): δ [ppm] = 8.94 (d, 1 H), 8.20 (d, 1 H), 7.81 (d, 1H), 7.75-7.70 (m, 2H), 7.60 (dd, 1 H), 7.52 (dd, 1 H), 7.45-7.40 (m, 4H).

### b) Synthese von (1,3-Pentandionato-κO,κO')bis[2-(3-chinolinyl-κN)phenyl-κC]iridium(III) (Ir1)

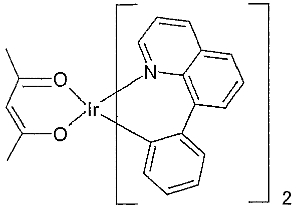

Ein Gemisch aus 1.76 g (5.0 mmol) Iridium(III)chlorid Hydrat, 2.26 g (11.0 mmol) 8-Phenylchinolin, 75 ml 2-Ethoxyethanol und 25 ml Wasser wird 48 h unter Rückfluss erhitzt. Die Reaktionsmischung wird am Vakuum eingeengt, der braune Rückstand wird in einem Gemisch aus 200 ml Wasser und 100 ml Ethanol aufgenommen und 1 h bei 60 °C ausgerührt. Der Feststoff wird abgesaugt und dreimal mit je 100 ml Ethanol gewaschen. Der braune Feststoff wird dann in 50 ml Ethoxyethanol suspendiert, mit 0.72 ml (7.0 mmol) Acetylaceton und 1.11 g (8.0 mmol) Kaliumcarbonat versetzt und 16 h unter Rückfluss erhitzt. Nach Erkalten wird der dunkelrote Niederschlag abgesaugt, dreimal mit je 100 ml eines Gemischs aus Ethanol / Wasser (1:1, v:v) und dann dreimal mit 100 ml Ethanol gewaschen.
Nach Trocknen wird der Niederschlag in 200 ml Dichlormethan gelöst. Die Lösung wird über Kieselgel filtriert, auf ein Volumen von 50 ml eingeengt und dann mit 100 ml n-Heptan versetzt. Erneute Umkristallisation aus Dichlomethan / *n*-Heptan ergibt 1.87 g (2.6 mmol), entsprechend 53.2 % d. Th., bei einer Reinheit von 99.5 % nach ¹H-NMR.
¹H-NMR (CDCl₃): δ [ppm] = 8.57 (d, 2H), 8.35 (d, 2H), 8.10 (d, 2H), 7.71 (d, 2H), 7.65-7.63 (m, 4H), 7.06 (dd, 2H), 6.96 (d, 2H), 6.72-6.66 (m, 4H), 4.25 (s, 1 H), 1.09 (s, 6H).

### Beispiel 2: (1,3-Pentandionato-κO,κO')bis[2-(8-chinolinyl-κN)(5-fluorphenyl)-κC]iridium(III), (Ir2)

### a) Synthese von 8-(4-Fluorphenyl)chinolin

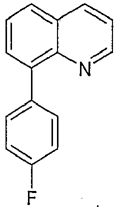

Durchführung analog Beispiel 1, jedoch werden statt Benzolboronsäure 14.0 g (100 mmol) 4-Fluorbenzolboronsäure verwendet. Die Ausbeute bei einer Reinheit von 99.5 % n. ¹H-NMR beträgt 8.4 g (37.5 mmol), entsprechend 75.0 % d. Th.
¹H-NMR (CDCl₃): δ [ppm] = 8.93 (dd, 1 H), 8.19 (dd, 1 H), 7.83 (dd, 1 H), 7.70 (d, 1 H), 7.68-7.64 (m, 4H), 7.60 (dd, 1 H), 7.40 (dd, 1 H).

### b) Synthese von (1,3-Pentandionato-κO,κO')bis[2-(8-chinolinyl-κN)(5-fluorphenyl)-κC]iridium(III) (Ir2)

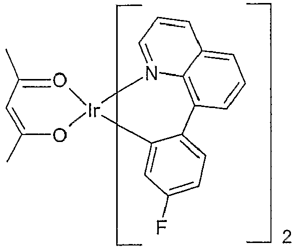

Durchführung analog Beispiel 1, jedoch werden statt 8-Phenylchinolin 2.46 g (11.0 mmol) 8-(4-Fluorphenyl)chinolin verwendet. Die Ausbeute bei einer Reinheit von 99.5 % n. ¹H-NMR beträgt 1.80 g (2.5 mmol), entsprechend 48.9 % d. Th.
¹H-NMR (CDCl₃): δ [ppm] = 8.51 (d, 2H), 8.24 (dd, 2H), 8.09 (dd, 2H), 7.66-7.61 (m, 6H), 6.99 (dd, 2H), 6.74 (ddd, 2H), 6.30 (dd, 2H), 4.25 (s, 1 H), 1.06 (s, 6H).

### Beispiel 3: (1,3-Pentandionato-κO,κO')bis[2-(8-chinolinyl-κN)(3,5-difluorphenyl)-κC]iridium(III) (Ir3)

### a) Synthese von 8-(2,4-Difluorphenyl)chinolin

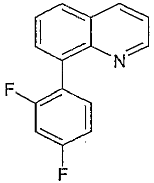

Durchführung analog Beispiel 1, jedoch werden statt Benzolboronsäure 15.8 g (100 mmol) 2,4-Difluorbenzolboronsäure verwendet. Die Ausbeute bei einer Reinheit von 99.0 % n. ¹H-NMR beträgt 9.3 g (38.5 mmol), entsprechend 77.1 % d. Th.
¹H-NMR (CDCl₃): δ [ppm] = 8.91 (dd, 1 H), 8.16 (dd, 1 H), 7.85 (dd, 1 H), 7.68 (d, 1 H), 7.60 (dd, 1 H), 7.50-7.44 (m, 1 H), 7.40 (dd, 1 H), 7.01-6.95 (m, 2H).

### b) Synthese von (1,3-Pentandionato-κO,κO')bis[2-(8-chinolinyl-κN)(3,5-difluorphenyl)-κC]iridium(III) (Ir3)

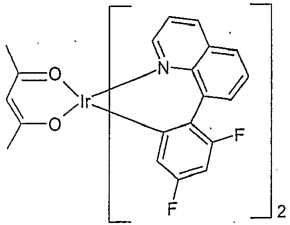

Durchführung analog Beispiel 1, jedoch werden statt 8-Phenylchinolin 2.65 g (11.0 mmol) 8-(2,4-Difluorphenyl)chinolin verwendet. Die Ausbeute bei einer Reinheit von 99.5 % n. ¹H-NMR beträgt 1.78 g (2.3 mmol), entsprechend 46.1 % d. Th.
¹H-NMR (CDCl₃): δ [ppm] = 8.45 (dd, 2H), 8.37 (dd, 2H), 8.14 (dd, 2H), 7.70-7.63 (m, 4H), 7.04 (dd, 2H), 6.50 (m, 2H), 6.11 (dd, 2H), 4.18 (s, 1 H), 1.03 (s, 6H).

### Beispiel 4: (1,3-Pentandionato-κO,κO')bis[2-(8-chinolinyl-κN)(4,6-difluorphenyl)-κC]iridium(III) (Ir4)

### a) Synthese von 8-(3,5-Difluorphenyl)chinolin

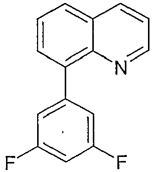

Durchführung analog Beispiel 1, jedoch werden statt Benzolboronsäure 15.8 g (100 mmol) 3,5-Difluorbenzolboronsäure verwendet. Die Ausbeute bei einer Reinheit von 99.5 % n. ¹H-NMR beträgt 10.3 g (43 mmol), entsprechend 85.4 % d. Th.
¹H-NMR (CDCl₃): δ [ppm] = 8.94 (dd, 1 H), 8.18 (d, 1 H), 7.84 (d, 1 H), 7.69 (dd, 1 H), 7.60 (dd, 1 H), 7.42 (dd, 1 H), 7.26-7.21 (m, 2H), 6.87 (m, 1 H).

### b) Synthese von (1,3-Pentandionato-κO,κO')bis[2-(8-chinolinyl-κN)(4,6-difluorphenyl)-κC]iridium(III) (Ir4)

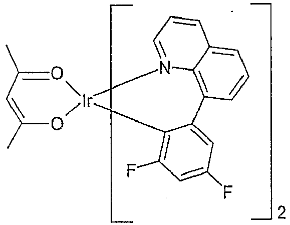

Durchführung analog Beispiel 1, jedoch werden statt 8-Phenylchinolin 2.65 g (11.0 mmol) 8-(3,5-Difluorphenyl)chinolin verwendet. Die Ausbeute bei einer Reinheit von 99.5 % n. ¹H-NMR beträgt 2.24 g (2.9 mmol), entsprechend 58.0 % d. Th.
¹H-NMR (CDCl₃): δ [ppm] = 8.55 (dd, 2H), 8.30 (dd, 2H), 8.09 (dd, 2H), 7.70-7.62 (m, 4H), 7.38 (dd, 2H), 6.99 (dd, 2H), 6.33 (m, 2H), 4.25 (s, 1 H), 1.08 (s, 6H).

### Beispiel 5: Tris[5,7,7',9-tetramethyl-7H-indeno[2,1-h]chinolin-11-yl-κN,-κC]iridium(III) (Ir5)

### a) Synthese von 2,7,9,9-Tetramethyl-fluoren

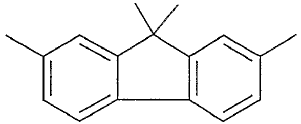

100 g (284 mmol) 2,7-Dibrom-9,9-dimethyl-fluoren werden in 1000 ml THF gelöst und bei -75 °C tropfenweise mit 227 ml (566 mmol) n-Butyllithium (2 M in Hexan) versetzt. Nach der Zugabe werden bei -78 °C 53 ml (850 mmol) Methyliodid zugetropft. Man lässt die Reaktionsmischung auf Raumtemperatur erwärmen und rührt anschließend weitere 3 h bei Raumtemperatur. Die Reaktionslösung wird anschließend unter Eiskühlung mit 120 ml halbkonzentrierter Salzsäure und dann mit 400 ml 50 %iger Ammoniak-Lösung versetzt. Es wird mit 300 ml Dichlormethan extrahiert, über MgSO₄ getrocknet und unter Vakuum eingeengt. Der erhaltene Feststoff wird abgesaugt und mit wenig Methanol gewaschen. Man erhält 57.8 g (260 mmol) eines weißen Feststoffes, entsprechend 91.5 % d. Th., mit einer Reinheit von 98.5 %.
¹H-NMR (CDCl₃): δ [ppm] = 7.56 (d, ³J_{HH} = 7.7, 2H), 7.21 (s, 2H), 7.12 (d, ³J_{HH} = 7.7 Hz, 2H), 2.41 (s, 6H), 1.45 (s, 6H).

### b) Synthese von 2,7,9,9-Tetramethyl-4-nitro-fluoren

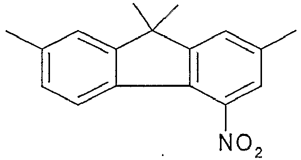

800 ml Dichlormethan werden auf -75 °C gekühlt und mit 26 ml (620 mmol) Salpetersäure und 926 ml Esigsäureanhydrid versetzt. Zu dieser Lösung werden 114.3 g (513 mmol) 2,7,9,9-Tetramethylfluoren, gelöst in 250 ml Dichlormethan, schnell zugegeben. Es wird 5 h bei -75 °C gerührt und dann langsam auf Raumtemperatur erwärmt. Danach wird die Mischung im Vakuum eingeengt und säulenchromatographisch mit Heptan:Toluol (20:1) gereinigt. Man erhält 70.4 g (263 mmol) eines weißen Feststoffes, entsprechend 51.3 % d. Th., mit einer Reinheit von 95.5 %.
¹H-NMR (CDCl₃): δ [ppm] = 7.91 (d, ³J_{HH} = 8.3, 1H), 7.63 (s, 1 H), 7.44 (s, 1 H), 7.24 (s, 1 H), 7.14 (d, ³J_{HH} = 8.3 H, 1 H), 2.47 (s, 3H), 2.43 (s, 3H), 1.47 (s, 6H).

### c) Synthese von 2,7,9,9-Tetramethyl-4-amino-fluoren

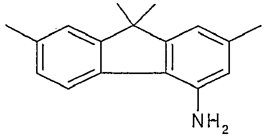

294 ml konzentrierte Salzsäure, 1400 ml Ethanol und 67.5 g (253 mmol)
2,7,9,9-Tetramethyl-4-nitro-fluoren werden vorgelegt und bei Raumtemperatur portionsweise mit 70.0 g (589 mmol) Zinn-Pulver versetzt. Nach der Zugabe wird die Mischung 3 h bei Raumtemperatur gerührt. Danach wird die Reaktionsmischung unter Eiskühlung durch Zugabe von NaOH (fest) auf pH = 12 eingestellt. Der Rückstand wird abfiltriert, mit Dichlormethan gewaschen und aus Heptan umkristallisiert. Man erhält 37.8 g (159 mmol) eines weißen Feststoffes, entsprechend 62.9 % d. Th., mit einer Reinheit von 95.0 %. ¹H-NMR (CDCl₃): δ [ppm] = 7.65 (d, ³J_{HH} = 7.7, 1 H), 7.41 (s, 1 H), 7.29 (d, ³J_{HH} = 7.7 Hz, 1 H), 6.89 (s, 1 H), 6.58 (s, 1 H), 4.15 (s, 2H), 2.59 (s, 3H), 2.49 (s, 3H), 1.62 (s, 6H).

### d) Synthese von 5,7,7,9-Tetramethyl-7H-indeno[2,1-h]chinolin

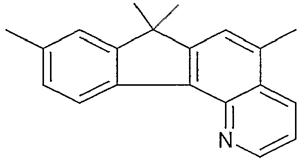

Zu einem Gemisch aus 4.9 g (20.6 mmol) 2,7,9,9-Tetramethyl-4-amino-fluoren, 3.6 g
(15.7 mmol) Arsen(V)-oxid und 7.16 g (77.3 mmol) Glycerin tropft man unter intensivem Rühren innerhalb von 15 min 6.5 g (64 mmol) konzentrierte Schwefelsäure zu. Die Mischung wird 6 h auf 165 °C erhitzt. Nach dem Abkühlen auf Raumtemperatur gießt man in 70 ml Eiswasser, fügt unter Kühlung konzentrierten Ammoniak bis zur alkalischen Reaktion zu und extrahiert mit Dichormethan. Nach dem Entfernen des Lösungsmittels wird aus Ethanol umkristallisiert. Man erhält 1.4 g (5.1 mmol) eines gelben Feststoffes, entsprechend 24.7 % d. Th., mit einer Reinheit von 99.7%.
¹H-NMR (CDCl₃): d [ppm] = 9.03 (dd, ⁴J_{HH} = 1.6 Hz, ³J_{HH} = 4.0 Hz, 1 H), 8.83 (d, ³J_{HH} = 7.7 Hz, 1 H), 8.36 (dd, ⁴J_{HH} = 1.6 Hz, ³J_{HH} = 8.3 Hz, 1 H), 7.49 (s, 1 H), 7.43 (dd, ⁴J_{HH} = 4.0 Hz, ³J_{HH} = 8.3 Hz, 1 H), 7.29 (s, 1 H), 7.24 (d, ³J_{HH} = 7.7 Hz,1 H), 2.79 (s, 3H), 2.48 (s, 3H), 1.55 (s, 6H).

### e) Synthese von Tris[5,7,7',9-tetramethyl-7H-indeno[2,1-h]chinolin-11-yl]iridium(III) (Ir5)

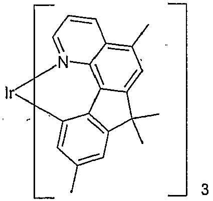

Ein Gemisch aus 484 mg (1.0 mmol) Na[Ir(acac)₂Cl₂], 1.64 g (6.0 mmol) 5,7,7,9-Tetramethyl-7H-indeno[2,1-h]chinolin und 10 ml Ethylenglykol wird 140 h auf 180 °C erhitzt. Nach Erkalten wird die Mischung in ein Gemisch aus 50 ml Ethanol und 25 ml 1N Salzsäure gegossen und 1 h bei Raumtemperatur gerührt. Der ausgefallene Feststoff wird abgesaugt, dreimal mit 30 ml Wasser und dann dreimal mit 30 ml Ethanol gewaschen und im Vakuum getrocknet. Anschließend wird der tiefrote Feststoff an Kieselgel (CH₂Cl₂ / n-Hexan, 1:6) chromatographiert. Die Ausbeute beträgt 332 mg (0.3 mmol), entsprechend 32.9 % d. Th., bei einer Reinheit von 99.5 % nach ¹H-NMR.
¹H-NMR (CDCl₃): δ [ppm] = 8.76 (d, 3H), 8.26 (d, 3H), 7.47 (s, 3H), 7.40 (dd, 3H), 7.01 (s, 3H), 6.83 (s, 3H), 3.02 (s, 9H), 2.67 (s, 9H), 1.63 (s, 18H).

### Beispiel 6: (1,3-Pentandionato-κO,κO')[2-(8-chinolinyl-κN)phenyl-κC]platin(II), (Pt1)

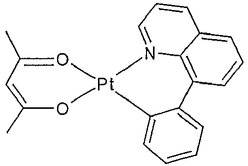

Ein Gemisch aus 2.07 g (5.0 mmol) Kaluimtetrachloroplatinat , 2.23 g (6.0 mmol) 8-Phenylchinolin, 75 ml 2-Ethoxyethanol und 25 ml Wasser wird 48 h unter Rückfluss erhitzt. Die Reaktionsmischung wird am Vakuum eingeengt, der braune Rückstand wird in einem Gemisch aus 200 ml Wasser und 100 ml Ethanol aufgenommen und 1 h bei 60 °C ausgerührt. Der Feststoff wird abgesaugt und dreimal mit je 100 ml Ethanol gewaschen. Der braune Feststoff wird dann in 50 ml Ethoxyethanol suspendiert, mit 0.72 ml (7.0 mmol) Acetylaceton und 1.11 g (8.0 mmol) Kaliumcarbonat versetzt und 16 h unter Rückfluss erhitzt. Nach Erkalten wird der dunkelrote Niederschlag abgesaugt, dreimal mit je 100 ml eines Gemischs aus Ethanol / Wasser (1:1, v:v) und dann dreimal mit 100 ml Ethanol gewaschen.
Nach Trocknen wird der Niederschlag in 200 ml Dichlormethan gelöst. Die Lösung wird über Kieselgel filtriert und anschließend an Kieselgel (CH₂Cl₂ / *n*-Hexan, 1:5) chromatographiert. Die Ausbeute beträgt 0.81 g (1.6 mmol), entsprechend 32.4 % d. Th., bei einer Reinheit von 99.5 % nach ¹H-NMR.
¹H-NMR (CDCl₃): δ [ppm] = 8.63 (m, 1 H), 8.31 (m, 1 H), 8.08 (d, 1 H), 7.67 (d, 1 H), 7.68-7.64 (m, 2H), 7.01 (dd, 1 H), 6.95 (d, 1 H), 6.42-6.40 (m, 2H), 4.26 (s, 1 H), 1.11 (br. s, 6H).

### Beispiel 7-13: Herstellung und Charakterisierung von organischen Elektrolumineszenzvorrichtungen, die erfindungsgemäße Verbindungen Ir1-Ir5 und Pt1 enthalten

Erfindungsgemäße Elektrolumineszenzvorrichtungen können, wie beispielsweise in WO 05/003253 beschrieben, dargestellt werden.
Hier werden die Ergebnisse zweier verschiedener OLEDs gegenübergestellt. Der grundlegende Aufbau, die verwendeten Materialien, der Dotierungsgrad und ihre Schichtdicken sind zur besseren Vergleichbarkeit identisch. Es wird ausschließlich der Dotand in der Emissionsschicht variiert.
Das erste Beispiel beschreibt einen Vergleichsstandard nach dem Stand der Technik, bei dem die Emissionsschicht aus dem Wirtsmaterial CBP und dem Gastmaterial Ir(piq)₃ besteht. Des Weiteren wird eine OLED mit einer Emitterschicht bestehend aus dem Wirtsmaterial CBP und den Gastmaterialien **Ir1** bis **Ir5** und **Pt1** (hergestellt gemäß den

Beispielen 1 bis 6) beschrieben. Analog dem o. g. allgemeinen Verfahren, werden OLEDs mit folgendem Aufbau erzeugt:

| | |
|---|---|
| PEDOT | 60 nm (aus Wasser aufgeschleudert; PEDOT bezogen von H. C. Starck, Goslar; Poly-[3,4-ethylendioxy-2,5-thiophen]), (HIL) |
| NaphDATA | 20 nm (aufgedampft; NaphDATA bezogen von SynTec; 4,4',4"-Tris(N-1-naphthyl)-N-phenyl-amino)-triphenylamin, (HTL) |
| S-TAD | 20 nm (aufgedampft; S-TAD synthetisiert nach WO 99/12888; 2,2',7,7'-Tetrakis(diphenylamino)-spirobifluoren), (HTL) |
| Emitter-Schicht: | (EML) |
| CPB | 20 nm (aufgedampft; CPB bezogen von ALDRICH und weiter gereinigt, schließlich noch zweimal sublimiert; 4,4'-Bis-(N-carbazolyl)biphenyl) |
| **Ir1** bis **Ir5** | |
| bzw. **Pt1** | (10 % Dotierung, aufgedampft; synthetisiert nach Beispiel 1 bis 6) |
| ODER: | |
| Ir(piq)₃ | (10 % Dotierung, aufgedampft; synthetisiert nach WO 03/0068526), Vergleichsbeispiel. |
| BCP | 10 nm (aufgedampft; BCP bezogen von ABCR, verwendet wie erhalten; 2,9-Dimethyl-4,7-diphenyl-1,10-phenanthrolin), (HBL) |
| AlQ₃ | 10 nm (aufgedampft: AlQₛ bezogen von SynTec; Tris(chinolinato)aluminium(III)), (ETL) |
| LiF | 1 nm |
| Al | 100 nm |

Diese noch nicht optimierten OLEDs werden standardmäßig charakterisiert; hierfür werden die Elektrolumineszenzspektren, die Effizienz (gemessen in cd/A) in Abhängigkeit von der Helligkeit, berechnet aus Strom-Spannungs-Helligkeit-Kennlinien (IUL-Kennlinien), und die Lebensdauer bestimmt.

### Effizienz als Funktion der Helligkeit, Farbe, Betriebsspannung, Lebensdauer:

Mit OLEDs hergestellt mit dem Dotanden Ir(piq)₃ erhält man unter den oben beschriebenen Bedingungen typischerweise eine maximale Effizienz von etwa 6.5 cd/A bei Farbkoordinaten von CIE: x = 0.68, y = 0.32. Für die Referenzleuchtdichte von 100 cd/m² werden Spannungen von 6.2 V benötigt. Die Lebensdauer beträgt etwa 250 h bei einer Anfangsleuchtdichte von 500 cd/m² (s. Tabelle 1).
Im Gegensatz dazu zeigen OLEDs hergestellt mit den erfindungsgemäßen Dotanden **Ir1** bis **Ir5** maximale Effizienzen von 4.8 bis 6.8 cd/A bei Farbkoordinaten von CIE: x =0.68-0.70, y = 0.32-0.30, wobei die benötigte Spannungen für die Referenzleuchtdichte von 100 cd/m² im Bereich von 5.2 bis 5.8 V liegen (s. Tabelle 1). Die Lebensdauer bei einer Anfangsleuchtdichte von 500 cd/m² ist mit 280 h bis 470 h besser als die des Referenzmaterials Ir(piq)₃ (s. Tabelle 1).
OLEDs hergestellt mit dem erfindungsgemäßen Dotanden **Pt1** zeigen eine maximale Effizienzen von 4.3 cd/A bei Farbkoordinaten von CIE: x = 0.72, y = 0.28, wobei die benötigte Spannungen für die Referenzleuchtdichte von 100 cd/m² bei 6.0 V liegen (s. Tabelle 1). Die Lebensdauer bei einer Anfangsleuchtdichte von 500 cd/m² ist mit 310 h besser als die des Referenzmaterials Ir(piq)₃ (s. Tabelle 1).

**Tabelle 1: Device-Ergebnisse mit erfindungsgemäßen Dotanden in CBP als Matrix**

| Experiment | EML | Max. Effizienz [cd/A] | Spannung [V] bei 100 cd/m² | CIE (x,y) | Lebensdauer [h] Anfangshelligkeit 500 [cd/m²] |
|---|---|---|---|---|---|
| Beispiel 7 (Vergleich) | CBP :10% Ir(piq)₃ (30 nm) | 6.5 | 6.2 | 0.68/0.32 | 250 |
| Beispiel 8 | CBP:10% Ir1 (30 nm) | 4.8 | 5.2 | 0.70/0.30 | 390 |
| Beispiel 9 | CBP:10% Ir2 (30 nm) | 4.9 | 5.7 | 0.70/0.30 | 470 |
| Beispiel 10 | CBP:10% Ir3 (30 nm) | 6.8 | 5.8 | 0.68/0.32 | 420 |
| Beispiel 11 | CBP:10% Ir4 (30 nm) | 5.5 | 5.6 | 0.69/0.31 | 330 |
| Beispiel 12 | CBP:10% Ir5 (30 nm) | 6.6 | 5.3 | 0.68/0.32 | 370 |
| Beispiel 13 | CBP:10% Pt1 (30 nm) | 4.3 | 6.0 | 0.72/0.28 | 310 |

### Beispiele 14 bis 19: Weitere Device-Beispiele mit erfindungsgemäßen Dotanden

Die erfindungsgemäßen Dotanden **Ir1** bis **Ir5** und **Pt1** sowie das Vergleichsbeispiel Ir(piq)₃ gemäß dem Stand der Technik werden in OLEDs, enthaltend das Matrixmaterial **M1** gemäß WO 04/093207, getestet. Analog dem in Beispiel 7-13 aufgeführten Verfahren wurden OLEDs mit folgendem Aufbau erzeugt:

| | |
|---|---|
| PEDOT | 80 nm (aus Wasser aufgeschleudert; PEDOT bezogen von H. C. Starck, Goslar; Poly-[3,4-ethylendioxy-2,5-thiophen]), (HIL) |
| NaphDATA | 20 nm (aufgedampft; NaphDATA bezogen von SynTec; 4,4',4"-Tris(N-1-naphthyl)-N-phenyl-amino)-triphenylamin), (HTL) |
| S-TAD | 20 nm (aufgedampft; S-TAD synthetisiert nach WO 99/12888; 2,2',7,7'-Tetrakis(diphenylamino)-spirobifluoren), (HTL) |
| Emitter-Schicht: | (EML) |
| **M1** | Bis(9,9'-spirobifluoren-2-yl)keton (aufgedampft, synthetisiert nach WO 2004/093207) |
| **Ir1** bis **Ir5** | |
| bzw. **Pt1** | (10 % Dotierung, aufgedampft; synthetisiert nach Beispiel 1 bis 6) |
| ODER: | |
| Ir(piq)₃ | (10 % Dotierung, aufgedampft; synthetisiert.nach WO 03/0068526) |
| **HBM1** | 2,7-Bis(4-biphenyl-1-yl)-2',7'-di-*tert*-butyl-spiro-9,9'-bifluoren (aufgedampft; synthetisiert nach WO 05/011334) |
| AlQ₃ | (aufgedampft; AlQ₃ bezogen von SynTec; Tris(chinolinato)aluminium(III)), (ETL); |
| Ba-Al | 3 nm Ba, darauf 150 nm Al. |

Diese noch nicht optimierten OLEDs werden standardmäßig charakterisiert; hierfür werden die Elektrolumineszenzspektren, die Effizienz (gemessen in cd/A) in Abhängigkeit von der Helligkeit, berechnet aus Strom-Spannungs-Helligkeit-Kennlinien (IUL-Kennlinien), und die Lebensdauer bestimmt. Die Ergebnisse, die mit diesen OLEDs erhalten werden, sind in Tabelle 2 zusammengefasst.
Das Matrixmaterial **M1,** das Lochblockiermaterial **HBM1** und der Vergleichsdotand Ir(piq)₃ sind im Folgenden der Übersichtlichkeit halber abgebildet:

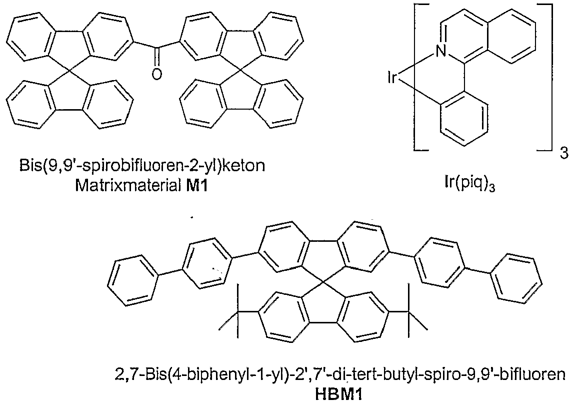

**Tabelle 2: Device-Ergebnisse mit erfindungsgemäßen Dotanden in M1 als Matrix**

| Experiment | EML | Max. Effizienz [cd/A] | Spannung [V] bei 100 cd/m² | CIE (x, y) | Lebensdauer [h] Anfangshelligkeit 1000 [cd/m²] |
|---|---|---|---|---|---|
| Beispiel 7 (Vergleich) | M1 :10% Ir(piq)₃ (30 nm) | 7.4 | 5.8 | 0.68/0.32 | 8300 |
| Beispiel 14 | CBP:10% Ir1 (30 nm) | 5.3 | 5.0 | 0.70/0.30 | 16500 |
| Beispiel 15 | M1:10% Ir2 (30 nm) | 5.5 | 4.9 | 0.70/0.30 | 13600 |
| Beispiel 16 | M1:10% Ir3 (30 nm) | 8.2 | 5.3 | 0.68/0.32 | 15100 |
| Beispiel 17 | M1:10% Ir4 (30 nm) | 7.7 | 5.2 | 0.69/0.31 | 9700 |
| Beispiel 18 | M1:10% Ir5 (30 nm) | 8.7 | 5.1 | 0.68/0.32 | 17500 |
| Beispiel 19 | M1:10% Pt1 (30 nm) | 4.8 | 4.9 | 0.71/0.29 | 14200 |

## Patentansprüche

1. Verbindungen gemäß Formel (1)
M(L)ₙ(L')ₘ(L")ₒ Formel (1)
enthaltend eine Teilstruktur M(L)ₙ gemäß Formel (2a), 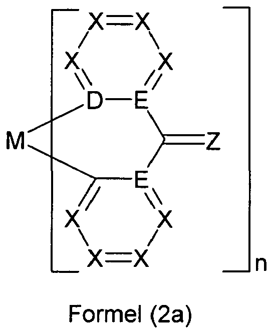 wobei für die verwendeten Symbole und Indizes gilt:
M ist bei jedem Auftreten Mo, W, Re, Ru, Os, Rh, Ir, Pd, Pt oder Au;
D ist gleich oder verschieden bei jedem Auftreten Stickstoff oder Phosphor;
X ist gleich oder verschieden bei jedem Auftreten CR¹, N oder P; oder
(X-X) bzw. (X=X) (also zwei benachbarte X) steht für NR¹, S oder O, mit der Maßgabe, dass Cy1 und Cy2 jeweils einen Fünf- oder Sechsring bilden; oder
(X-X) bzw. (X=X) (also zwei benachbarte X) steht für CR¹, N oder P, falls das Symbol E im entsprechenden Cyclus für N steht;
E ist gleich oder verschieden bei jedem Auftreten C oder N mit der Maßgabe, dass, falls das Symbol E für N steht, genau eine Einheit X-X (also zwei benachbarte X) im entsprechenden Cyclus gleich CR¹, N oder P ist;
Z ist gleich oder verschieden bei jedem Auftreten C(R)₂ oder NR;
R ist gleich oder verschieden bei jedem Auftreten H, F, CN, eine geradkettige Alkyl- oder Alkoxygruppe mit 1 bis 40 C-Atomen oder eine verzweigte oder cyclische Alkyl- oder Alkoxygruppe mit 3 bis 40 C-Atomen, wobei jeweils eine oder mehrere nicht benachbarte CH₂-Gruppen durch -R²C=CR²-, -C≡C-, Si(R²)₂, Ge(R²)₂, Sn(R²)₂, -O-, -S-, -NR²-, -(C=O)-, -(C=NR²)-, -P=O(R²)-, SO, SO₂ oder -CONR²- ersetzt sein können und wobei ein oder mehrere H-Atome durch F ersetzt sein können, oder ein aromatisches oder heteroaromatisches Ringsystem bzw. eine Aryloxy- oder Heteroaryloxygruppe mit 5 bis 40 aromatischen Ringatomen, welches durch einen oder mehrere nicht-aromatische Reste R substituiert sein kann, oder eine Kombination aus zwei, drei oder vier dieser Systeme; dabei kann R auch ein Ringsystem mit X bzw. mit R¹ bilden ;
R¹ ist gleich oder verschieden bei jedem Auftreten H, F, Cl, Br, I, OH, NO₂, CN, N(R²)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, wobei jeweils eine oder mehrere nicht benachbarte CH₂-Gruppen durch -R²C=CR²-, -C≡C-, Si(R²)₂, Ge(R²)₂, Sn(R²)₂,-O-, -S-, -NR²-, -(C=O)-, -(C=NR²)-, -P=O(R²)-, SO, SO₂, -COOR²- oder -CONR²-ersetzt sein können und wobei ein oder mehrere H-Atome durch F, Cl, Br, I oder CN ersetzt sein können, oder ein aromatisches oder heteroaromatisches Ringsystem bzw. eine Aryloxy- oder Heteroaryloxygruppe mit 5 bis 40 aromatischen Ringatomen, welches durch einen oder mehrere nicht-aromatische Reste R¹ substituiert sein kann, oder eine Kombination aus zwei, drei oder vier dieser Systeme; dabei können mehrere Substituenten R¹, sowohl am selben Ring als auch an unterschiedlichen Ringen zusammen, oder auch R¹ und R und/oder R² wiederum ein weiteres mono- oder polycyclisches, aliphatisches, aromatisches oder heteroaromatisches Ringsystem aufspannen;
R² ist gleich oder verschieden bei jedem Auftreten H oder ein aliphatischer oder aromatischer Kohlenwasserstoffrest mit 1 bis 20 C-Atomen;
n ist 1, 2 oder 3;
dabei sind die Liganden L' und L" in Formel (1) monoanionische, zweizähnig chelatisierende Liganden; m und o sind gleich oder verschieden bei jedem Auftreten 0, 1 oder 2; und n + m + o = 2 oder 3.

2. Verbindungen der Formel (1a) gemäß Anspruch 1,
M(L)ₙ(L')ₘ(L")ₒ Formel (1a)
enthaltend mindestens eine Teilstruktur M(L)ₙ der Formel (2b), gleich oder verschieden bei jedem Auftreten, 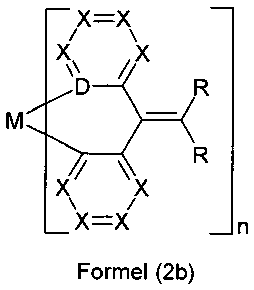 und gegebenenfalls enthaltend eine Teilstruktur M(L')ₘ der Formel (3), gleich oder verschieden bei jedem Auftreten, 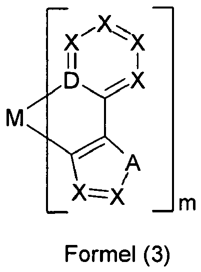 wobei M, D, R, R¹, R², L", n, m und o dieselbe Bedeutung haben, wie in Anspruch 1 beschrieben, und weiterhin gilt:
X ist gleich oder verschieden bei jedem Auftreten CR¹, N oder P; oder
(X-X) bzw. (X=X) (also zwei benachbarte X) steht für NR¹, S oder O;
A ist gleich oder verschieden bei jedem Auftreten -CR¹=CR¹-, -N=CR¹-, -P=CR¹-, -N=N-, -P=N-, NR¹, PR¹, O, S oder Se.

3. Verbindungen gemäß Anspruch 1 oder 2, enthaltend eine Teilstruktur M(L)ₙ gemäß Formel (2c), gemäß Formel (2d) oder gemäß Formel (2e), 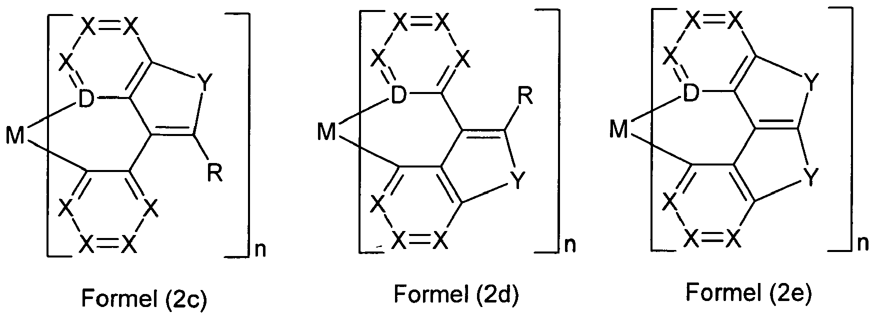 wobei M, X, D, R, R¹, R² und n dieselbe Bedeutung haben, wie in Anspruch 1, 2 und 3 beschrieben, und für das Symbol Y gilt:
Y ist bei jedem Auftreten gleich oder verschieden eine bivalente Gruppe ausgewählt aus -C(R¹)₂-, -C(=O)-, -C[=C(R¹)₂]-, -C(R¹)₂-C(R¹)₂-, -C(=O)-O-, - C(=O)-N(R¹)-, -C(R¹)₂-C(R¹)₂-C(R¹)₂-, -C(R¹)₂-O-C(R¹)₂-, -C(R¹)₂-N(R¹)-, -C(R¹)=C(R¹)-, -C(R¹)=N-, -O-, -S-, -N(R¹)-, -P(R¹)-, -P(=O)(R¹)- und -B(R¹)-.

4. Verbindungen gemäß einem oder mehreren der Ansprüche 1 bis 3, **dadurch gekennzeichnet, dass** die monoanionischen, zweizähnigen Liganden L" ausgewählt sind aus der Gruppe der 1,3-Diketonate abgeleitet von 1,3-Diketonen, der 3-Ketonate abgeleitet von 3-Ketoestern, der Carboxylate abgeleitet von Aminocarbonsäuren, der Salicyliminate abgeleitet von Salicyliminen und der Borate stickstoffhaltiger Heterocyclen.

5. Verbindungen gemäß einem oder mehreren der Ansprüche 1 bis 4, **dadurch gekennzeichnet, dass** für das Symbol M = Rh, Ir, Pd oder Pt gilt.

6. Verbindungen gemäß einem oder mehreren der Ansprüche 1 bis 5, **dadurch gekennzeichnet, dass** für das Symbol n = 2 oder 3 gilt.

7. Verbindungen gemäß einem oder mehreren der Ansprüche 1 bis 6, **dadurch gekennzeichnet, dass** für das Symbol o = 0 gilt.

8. Verbindungen gemäß einem oder mehreren der Ansprüche 1 bis 7, **dadurch gekennzeichnet, dass** für das Symbol Z = C(R)₂ gilt.

9. Verbindungen gemäß einem oder mehreren der Ansprüche 1 bis 8, **dadurch gekennzeichnet, dass** für das Symbol D = N gilt.

10. Verbindungen gemäß einem oder mehreren der Ansprüche 1 bis 9, **dadurch gekennzeichnet, dass** für das Symbol X = CR¹ oder N gilt.

11. Verbindungen gemäß einem oder mehreren der Ansprüche 3 bis 10, **dadurch gekennzeichnet, dass** das Symbol Y in Formel (2c), (2d) bzw. (2e) für eine bivalente Gruppe -C(R¹)₂-, -C(=O)-, -C(R¹)₂-C(R¹)₂-, -C(R¹)₂-N(R¹)-, -C(R¹)=C(R¹)-, -C(R¹)=N-, -O-, -S- oder -N(R¹)- steht.

12. Verfahren zur Herstellung von Verbindungen gemäß einem oder mehreren der Ansprüche 1 bis 11 durch Umsetzung der entsprechenden freien Liganden mit Metallalkoholaten der Formel (4), mit Metallketoketonaten der Formel (5) oder ein- oder mehrkernigen Metallhalogeniden der Formeln (6), (7) oder (8), 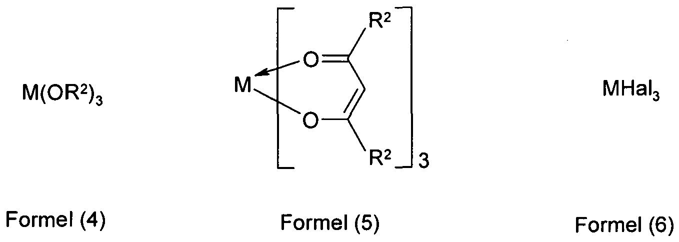 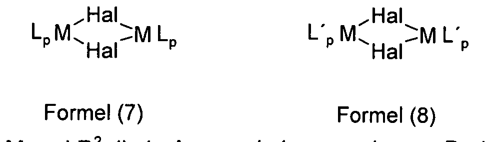 wobei die Symbole M und R² die in Anspruch 1 angegebenen Bedeutungen haben, p = 1 oder 2 und Hal = F, Cl, Br oder I ist.

13. Verfahren zur Herstellung von Verbindungen gemäß einem oder mehreren der Ansprüche 1 bis 12 durch Umsetzung der entsprechenden freien Liganden mit Metallverbindungen, die sowohl Alkoholat- und/oder Halogenid- und/oder Hydroxy- wie auch Ketoketonatreste tragen.

14. Konjugierte, teilkonjugierte oder nicht-konjugierte Oligomere, Polymere oder Dendrimere, enthaltend eine oder mehrere der Verbindungen gemäß einem oder mehreren der Ansprüche 1 bis 11, wobei mindestens einer der oben definierten Reste R bzw. R¹ eine Bindung zum Polymer oder Dendrimer darstellt.

15. Oligomere, Polymere oder Dendrimere gemäß Anspruch 14, **dadurch gekennzeichnet, dass** sie ausgewählt sind aus den Klassen der Polyfluorene, Polyspirobifluorene, Polypara-phenylene, Poly-dihydrophenanthrene, Poly-phenanthrene, Poly-indenofluorene, Polycarbazole, Polyketone, Polysilane oder Polythiophene oder Copolymere, die verschiedene dieser Einheiten enthalten.

16. Oligomere, Polymere oder Dendrimere gemäß Anspruch 14 und/oder 15, **dadurch gekennzeichnet, dass** die Verbindungen gemäß einem oder mehreren der Ansprüche 1 bis 11 in die Seitenkette oder in die Hauptkette des Polymers eingebaut werden oder Verzweigungspunkte der Polymerketten oder Endgruppen der Polymerketten darstellen.

17. Verwendung von Verbindungen, Oligomeren, Polymeren oder Dendrimeren gemäß einem oder mehreren der Ansprüche 1 bis 11 und/oder 14 bis 16 als aktive Komponente in elektronischen Bauteilen, insbesondere als emittierende Verbindung.

18. Elektronische Bauteile enthaltend eine oder mehrere Verbindungen gemäß einem oder mehreren der Ansprüche 1 bis 11 oder Oligomere, Polymere oder Dendrimere gemäß einem oder mehreren der Ansprüche 14 bis 16.

19. Elektronische Bauteile gemäß Anspruch 18, ausgewählt aus der Gruppe der organischen und polymeren Leuchtdioden (OLEDs, PLEDs), organischen Feld-Effekt-Transistoren (O-FETs), organischen Dünnfilmtransistoren (O-TFTs), organischen integrierten Schaltungen (O-ICs), organischen Solarzellen (O-SCs), organischen lichtemittierenden Transistoren (O-LETs), organischen Feld-Quench-Devices (O-FQDs), lichtemittierenden elektrochemischen Zellen (LECs) und organischen Laserdioden (O-Laser).

## Claims

1. Compounds of the formula (1)
M(L)ₙ(L')ₘ(L")ₒ formula (1)
containing a moiety M(L)ₙ of the formula (2a), 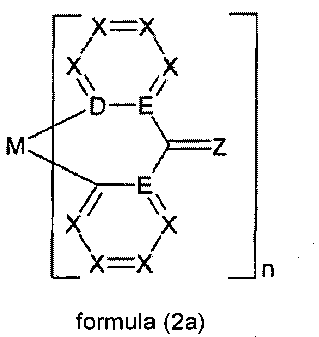 where the following applies to the symbols and indices used:
M is on each occurrence Mo, W, Re, Ru, Os, Rh, Ir, Pd, Pt or Au;
D is, identically or differently on each occurrence, nitrogen or phosphorus;
X is, identically or differently on each occurrence, CR¹, N or P; or
(X-X) or (X=X) (i.e. two adjacent X) stands for NR¹, S or O, with the proviso that Cy1 and Cy2 each form a five- or six-membered ring; or
(X-X) or (X=X) (i.e. two adjacent X) stands for CR¹, N or P if the symbol E in the corresponding ring stands for N;
E is, identically or differently on each occurrence, C or N, with the proviso that, if the symbol E stands for N, precisely one unit X-X (i.e. two adjacent X) in the corresponding ring is equal to CR¹, N or P;
Z is, identically or differently on each occurrence, C(R)₂ or NR;
R is, identically or differently on each occurrence, H, F, CN, a straight-chain alkyl or alkoxy group having 1 to 40 C atoms or a branched or cyclic alkyl or alkoxy group having 3 to 40 C atoms, where in each case one or more non-adjacent CH₂ groups may be replaced by -R²C=CR²-, -C≡C-, Si(R²)₂, Ge(R²)₂, Sn(R²)₂, -O-, -S-, -NR²-, -(C=O)-, -(C=NR²)-, -P=O(R²)-, SO, SO₂ or -CONR²- and where one or more H atoms may be replaced by F, or an aromatic or heteroaromatic ring system or an aryloxy or heteroaryloxy group having 5 to 40 aromatic ring atoms, which may be substituted by one or more non-aromatic radicals R, or a combination of two, three or four of these systems; R here may also form a ring system with X or with R¹;
R¹ is, identically or differently on each occurrence, H, F, Cl, Br, I, OH, NO₂, CN, N(R²)₂, a straight-chain alkyl, alkoxy or thioalkoxy group having 1 to 40 C atoms or a branched or cyclic alkyl, alkoxy or thioalkoxy group having 3 to 40 C atoms, where in each case one or more non-adjacent CH₂ groups may be replaced by -R²C=CR²-, -C≡C-, Si(R²)₂, Ge(R²)₂, Sn(R²)₂, -O-, -S-, -NR²-, -(C=O)-, -(C=NR²)-, -P=O(R²)-, SO, SO₂, -COOR²- or -CONR²- and where one or more H atoms may be replaced by F, Cl, Br, I or CN, or an aromatic or heteroaromatic ring system or an aryloxy or heteroaryloxy group having 5 to 40 aromatic ring atoms, which may be substituted by one or more non-aromatic radicals R¹, or a combination of two, three or four of these systems; a plurality of substituents R¹ here, both on the same ring and also on different rings together, or also R¹ and R and/or R² may in turn form a further mono- or polycyclic, aliphatic, aromatic or heteroaromatic ring system;
R² is, identically or differently on each occurrence, H or an aliphatic or aromatic hydrocarbon radical having 1 to 20 C atoms;
n is 1, 2 or 3;
the ligands L' and L" in formula (1) here are monoanionic, bidentate-chelating ligands; m and o are, identically or differently on each occurrence, 0, 1 or 2; and n + m + o = 2 or 3.

2. Compounds of the formula (1a) according to Claim 1,
M(L)ₙ(L')ₘ(L")ₒ formula (1a)
containing at least one moiety M(L)ₙ of the formula (2b), identically or differently on each occurrence, 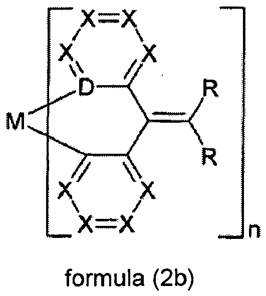 and optionally containing a moiety M(L')ₘ of the formula (3), identically or differently on each occurrence, 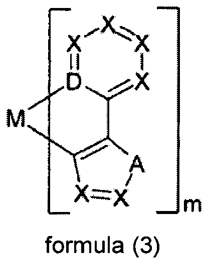 where M, D, R, R¹, R², L", n, m and o have the same meaning as described in Claim 1, and furthermore:
X is, identically or differently on each occurrence, CR¹, N or P; or
(X-X) or (X=X) (i.e. two adjacent X) stands for NR¹, S or O;
A is, identically or differently on each occurrence, -CR¹=CR¹-, -N=CR¹-, -P=CR¹-, -N=N-, -P=N-, NR¹, PR¹, O, S or Se.

3. Compounds according to Claim 1 or 2, containing a moiety M(L)ₙ of the formula (2c), of
the formula (2d) or of the formula (2e), 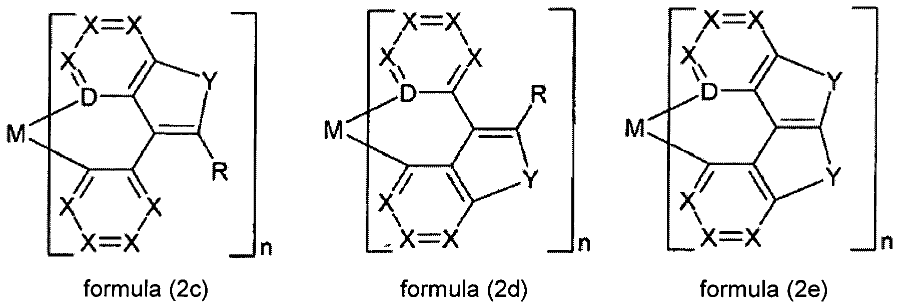 where M, X, D, R, R¹, R² and n have the same meaning as described in Claims 1, 2 and 3, and the following applies to the symbol Y:
Y is on each occurrence, identically or differently, a divalent group selected from -C(R¹)₂-, -C(=O)-, -C[=C(R¹)₂]-, -C(R¹)₂-C(R¹)₂-, -C(=O)-O-, -C(=O)-N(R¹)-, -C(R¹)₂-C(R¹)₂-C(R¹)₂-, -C(R¹)₂-O-C(R¹)₂-, -C(R¹)₂-N(R¹)-, -C(R¹)=C(R¹)-, -C(R¹)=N-, -O-, -S-, -N(R¹)-, -P(R¹)-, -P(=O)(R¹)- and -B(R¹)-.

4. Compounds according to one or more of Claims 1 to 3, **characterised in that** the monoanionic, bidentate ligands L" are selected from the group of the 1,3-diketonates derived from 1,3-diketones, the 3-ketonates derived from 3-ketoesters, the carboxylates derived from aminocarboxylic acids, the salicyliminates derived from salicylimines and the borates of nitrogen-containing heterocycles.

5. Compounds according to one or more of Claims 1 to 4, **characterised in that** the symbol M = Rh, Ir, Pd or Pt.

6. Compounds according to one or more of Claims 1 to 5, **characterised in that** the symbol n = 2 or 3.

7. Compounds according to one or more of Claims 1 to 6, **characterised in that** the symbol o = 0.

8. Compounds according to one or more of Claims 1 to 7, **characterised in that** the symbol Z = C(R)₂.

9. Compounds according to one or more of Claims 1 to 8, **characterised in that** the symbol D=N.

10. Compounds according to one or more of Claims 1 to 9, **characterised in that** the symbol X = CR¹ or N.

11. Compounds according to one or more of Claims 3 to 10, **characterised in that** the symbol Y in formula (2c), (2d) or (2e) stands for a divalent group -C(R¹)₂-, -C(=O)-, -C(R¹)₂-C(R¹)₂-, -C(R¹)₂-N(R¹)-, -C(R¹)=C(R¹)-, -C(R¹)=N-, -O-, -S- or -N(R¹)-.

12. Process for the preparation of compounds according to one or more of Claims 1 to 11 by reaction of the corresponding free ligands with metal alcoholates of the formula (4), with metal ketoketonates of the formula (5) or mono- or multinuclear metal halides of the formula (6), (7) or (8), 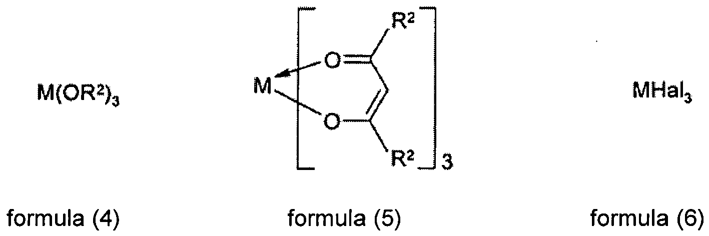 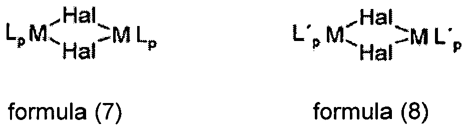 where the symbols M and R² have the meanings indicated in Claim 1, p = 1 or 2 and
Hal = F, Cl, Br or I.

13. Process for the preparation of compounds according to one or more of Claims 1 to 12 by reaction of the corresponding free ligands with metal compounds which carry both alcoholate and/or halide and/or hydroxyl and also ketoketonate radicals.

14. Conjugated, partially conjugated or non-conjugated oligomers, polymers or dendrimers comprising one or more of the compounds according to one or more of Claims 1 to 11, where at least one of the above-defined radicals R or R¹ represents a bond to the polymer or dendrimer.

15. Oligomers, polymers or dendrimers according to Claim 14, **characterised in that** they are selected from the classes of the polyfluorenes, polyspirobifluorenes, poly-para-phenylenes, polydihydrophenanthrenes, polyphenanthrenes, polyindenofluorenes, polycarbazoles, polyketones, polysilanes or polythiophenes or copolymers which contain various of these units.

16. Oligomers, polymers or dendrimers according to Claim 14 and/or 15, **characterised in that** the compounds according to one or more of Claims 1 to 11 are incorporated into the side chain or into the main chain of the polymer or represent branching points of the polymer chains or end groups of the polymer chains.

17. Use of compounds, oligomers, polymers or dendrimers according to one or more of Claims 1 to 11 and/or 14 to 16 as active component in electronic components, in particular as emitting compound.

18. Electronic components comprising one or more compounds according to one or more of Claims 1 to 11 or oligomers, polymers or dendrimers according to one or more of Claims 14 to 16.

19. Electronic components according to Claim 18, selected from the group of the organic and polymeric light-emitting diodes (OLEDs, PLEDs), organic field-effect transistors (O-FETs), organic thin-film transistors (O-TFTs), organic integrated circuits (O-ICs), organic solar cells (O-SCs), organic light-emitting transistors (O-LETs), organic field-quench devices (O-FQDs), light-emitting electrochemical cells (LECs) and organic laser diodes (O-lasers).

## Revendications

1. Composés de la formule (1)
M(L)ₙ(L')ₘ(L")ₒ formule (1)
contenant une moitié M(L)ₙ de la formule (2a), 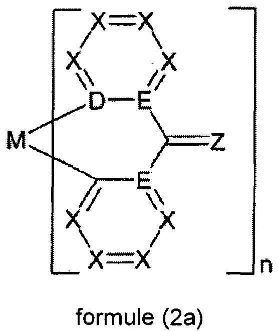 dans laquelle ce qui suit s'applique aux symboles et indices utilisés :
M est à chaque occurrence Mo, W, Re, Ru, Os, Rh, Ir, Pd, Pt ou Au ;
D est, de façon identique ou différente à chaque occurrence, azote ou phosphore ;
X est, de façon identique ou différente à chaque occurrence, CR¹, N ou P ; ou
(X-X) ou (X=X) (i.e. deux X adjacents) représente NR¹, S ou O, sous réserve que Cy1 et Cy2 forment chacun un cycle à cinq ou six branches ; ou
(X-X) ou (X=X) (i.e. deux X adjacents) représente CR¹, N ou P si le symbole E dans le cycle correspondant représente N ;
E est, de façon identique ou différente à chaque occurrence, C ou N, sous réserve que, si le symbole E représente N, précisément une unité X-X (i.e. deux X adjacents) dans le cycle correspondant est égale à CR¹, N ou P ;
Z est, de façon identique ou différente à chaque occurrence, C(R)₂ ou NR ;
R est, de façon identique ou différente à chaque occurrence, H, F, CN, un groupe alkyle ou alcoxy en chaîne droite ayant 1 à 40 atomes de C ou un groupe alkyle ou alcoxy ramifié ou cyclique ayant 3 à 40 atomes de C, où dans chaque cas un ou plusieurs groupes CH₂ non adjacents peuvent être remplacés par -R²C=CR²-, -C≡C-, Si(R²)₂, Ge(R²)₂, Sn(R²)₂, -O-, -S-, -NR²-, -(C=O)-, -(C=NR²)-, -P=O(R²)-, SO, SO₂ ou -CONR²- et où un ou plusieurs atomes de H peuvent être remplacés par F, ou un système de cycle aromatique ou hétéroaromatique ou un groupe aryloxy ou hétéroaryloxy ayant 5 à 40 atomes de cycle aromatique, qui peut être substitué par un ou plusieurs radicaux non aromatiques R, ou une combinaison de deux, trois ou quatre de ces systèmes ; R ici peut également former un système de cycle avec X ou avec R¹ ;
R¹ est, de façon identique ou différente à chaque occurrence, H, F, Cl, Br, I, OH, NO₂, CN, N(R²)₂, un groupe alkyle, alcoxy ou thioalcoxy en chaîne droite ayant 1 à 40 atomes de C ou un groupe alkyle, alcoxy ou thioalcoxy ramifié ou cyclique ayant 3 à 40 atomes de C, où dans chaque cas un ou plusieurs groupes CH₂ non adjacents peuvent être remplacés par -R²C=CR²-, -C≡C-, Si(R²)₂, Ge(R²)₂, Sn(R²)₂, -O-, -S-, -NR²-, -(C=O)-, -(C=NR²)-, -P=O(R²)-, SO, SO₂, -COOR²- ou -CONR²- et un ou plusieurs atomes de H peuvent être remplacés par F, Cl, Br, I ou CN, ou un système de cycle aromatique ou hétéroaromatique ou groupe aryloxy ou hétéroaryloxy ayant 5 à 40 atomes de cycle aromatique, qui peut être substitué par un ou plusieurs radicaux non aromatiques R¹, ou une combinaison de deux, trois ou quatre de ces systèmes ; une pluralité de substituants R¹ ici, à la fois sur le même cycle et également sur des cycles différents ensemble, ou également R¹ et R et/ou R² peuvent à leur tour former un système de cycle supplémentaire aliphatique, aromatique ou hétéroaromatique, mono- ou polycyclique ;
R² est, de façon identique ou différente à chaque occurrence, H ou un radical hydrocarbone aliphatique ou aromatique ayant 1 à 20 atomes de C ;
n est 1, 2 ou 3 ;
les ligands L' et L" dans la formule (1) sont ici des ligands monoanioniques, bidentéschélatants ; m et o sont, de façon identique ou différente à chaque occurrence, 0, 1 ou 2 ; et n + m + o = 2 ou 3.

2. Composés de la formule (1a) selon la revendication 1,
M(L)ₙ(L')ₘ(L")ₒ formule (1a)
contenant au moins une moitié M(L)ₙ de la formule (2b), de façon identique ou différente à chaque occurrence, 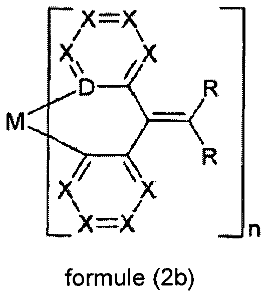 et contenant optionnellement une moitié M(L')ₘ de la formule (3), de façon identique ou différente à chaque occurrence, 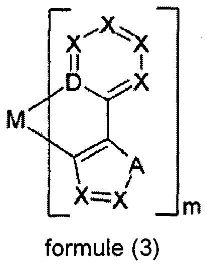 dans laquelle M, D, R, R¹, R², L", n, m et o ont la même signification que comme décrit dans la revendication 1, et en outre :
X est, de façon identique ou différente à chaque occurrence, CR¹, N ou P ; ou
(X-X) ou (X=X) (i.e. deux X adjacents) représente NR¹, S ou O ;
A est, de façon identique ou différente à chaque occurrence, -CR¹=CR¹-, -N=CR¹-, -P=CR¹-, -N=N-, -P=N-, NR¹, PR¹, O, S ou Se.

3. Composés selon la revendication 1 ou 2, contenant une moitié M(L)ₙ de la formule (2c),
de la formule (2d) ou de la formule (2e), 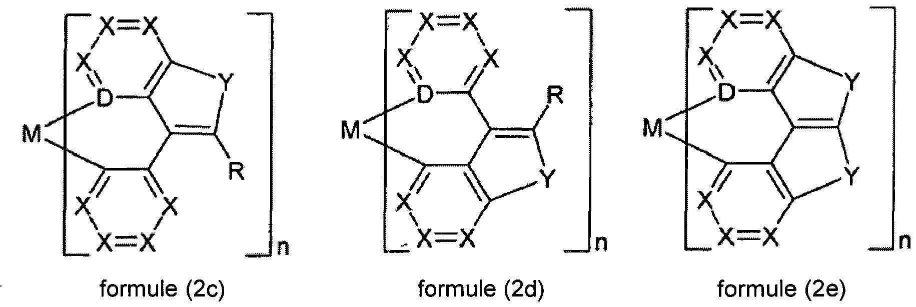 dans lesquelles M, X, D, R, R¹, R² et n ont la même signification que comme décrit dans les revendications 1, 2 et 3, et ce qui suit s'applique au symbole Y :
Y est à chaque occurrence, de façon identique ou différente, un groupe divalent choisi parmi -C(R¹)₂-, -C(=O)-, -C[=C(R¹)₂]-, -C(R¹)₂-C(R¹)₂-, -C(=O)-O-, -C(=O)-N(R¹)-, -C(R¹)₂-C(R¹)₂-C(R¹)₂-, -C(R¹)₂-O-C(R¹)₂-, -C(R¹)₂-N(R¹)-, -C(R¹)=C(R¹)-, -C(R¹)=N-, -O-, -S-, -N(R¹)-, -P(R¹)-, -P(=O)(R¹)- et -B(R¹)-.

4. Composés selon une ou plusieurs des revendications 1 à 3, **caractérisés en ce que** les ligands bidentés monoanioniques L" sont choisis parmi le groupe des 1,3-dicétonates dérivés des 1,3-dicétones, les 3-cétonates dérivés des 3-cétoesters, les carboxylates dérivés des acides aminocarboxyliques, les salicyliminates dérivés des salicylimines et les borates des hétérocycles contenant de l'azote.

5. Composés selon une ou plusieurs des revendications 1 à 4, **caractérisés en ce que** le symbole M = Rh, Ir, Pd ou Pt.

6. Composés selon une ou plusieurs des revendications 1 à 5, **caractérisés en ce que** le symbole n = 2 ou 3.

7. Composés selon une ou plusieurs des revendications 1 à 6, **caractérisés en ce que** le symbole o = 0.

8. Composés selon une ou plusieurs des revendications 1 à 7, **caractérisés en ce que** le symbole Z = C(R)₂.

9. Composés selon une ou plusieurs des revendications 1 à 8, **caractérisés en ce que** le symbole D = N.

10. Composés selon une ou plusieurs des revendications 1 à 9, **caractérisés en ce que** le symbole X = CR¹ ou N.

11. Composés selon une ou plusieurs des revendications 3 à 10, **caractérisés en ce que** le symbole Y dans la formule (2c), (2d) ou (2e) représente un groupe divalent -C(R¹)₂-, -C(=O)-, -C(R¹)₂-C(R¹)₂-, -C(R¹)₂-N(R¹)-, -C(R¹)=C(R¹)-, -C(R¹)=N-, -O-, -S- ou -N(R¹)-.

12. Procédé pour la préparation de composés selon une ou plusieurs des revendications 1 à 11 par réaction des ligands libres correspondants avec un alcoolate de métal de la formule (4), avec des cétocétonates de métal de la formule (5) ou des halogénures de métal mono- ou multinucléaires de la formule (6), (7) ou (8), 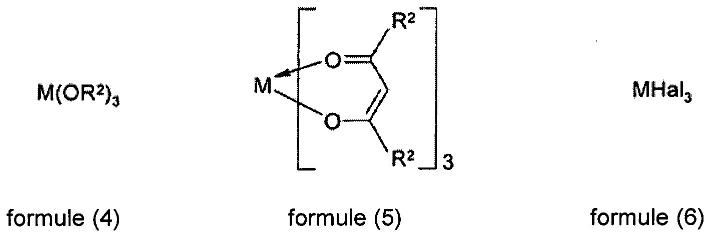 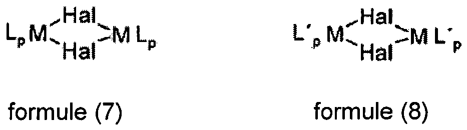 dans lesquelles les symboles M et R² ont les significations indiquées dans la revendication 1, p = 1 ou 2 et Hal = F, CI, Br ou I.

13. Procédé pour la préparation de composés selon une ou plusieurs des revendications 1 à 12 par réaction des ligands libres correspondants avec des composés de métal qui portent à la fois un alcoolate et/ou un halogénure et/ou un hydroxyle et également des radicaux cétocétonate.

14. Oligomères, polymères ou dendrimères conjugués, partiellement conjugués ou non conjugués comprenant un ou plusieurs des composés selon une ou plusieurs des revendications 1 à 11, où au moins un des radicaux définis ci-avant R ou R¹ représentent une liaison au polymère ou dendrimère.

15. Oligomères, polymères ou dendrimères selon la revendication 14, **caractérisés en ce qu'**ils sont choisis parmi les classes des polyfluorènes, polyspirobifluorènes, poly-para-phénylènes, polydihydrophénanthrènes, polyphénanthrènes, polyindénofluorènes, polycarbazoles, polycétones, polysilanes ou polythiophènes ou copolymères qui contiennent diverses de ces unités.

16. Oligomères, polymères ou dendrimères selon la revendication 14 et/ou 15, **caractérisés en ce que** les composés selon une ou plusieurs des revendications 1 à 11 sont incorporés dans la chaîne latérale ou dans la chaîne principale du polymère ou représentent des points de ramification des chaînes de polymère ou des groupes finaux des chaînes de polymère.

17. Utilisation des oligomères, polymères ou dendrimères selon une ou plusieurs des revendications 1 à 11 et/ou 14 à 16 en tant que composant actif dans des composants électroniques, en particulier en tant que composés d'émission.

18. Composants électroniques comprenant un ou plusieurs composés selon une ou plusieurs des revendications 1 à 11 ou oligomères, polymères ou dendrimères selon une ou plusieurs des revendications 14 à 16.

19. Composants électroniques selon la revendication 18, choisis parmi le groupe des diodes émettrices de lumière organiques et polymériques (OLEDs, PLEDs), transistors à effet de champ organiques (O-FETs), transistors à film mince organiques (O-TFTs), circuits intégrés organiques (O-ICs), cellules solaires organiques (O-SCs), transistors émetteurs de lumière organiques (O-LETs), dispositifs à extinction de champ organiques (O-FQDs), cellules électrochimiques émettrices de lumière (LECs) et diodes laser organiques (O-lasers).
